# EUROPEAN PATENT APPLICATION

(11) **EP 2 019 440 A2**
(43) Date of publication of application: **28.01.2009**
(21) Application number: 08102433.3
(22) Date of filing: 10.03.2008
(51) Int. Cl.: H01L 51/52, H01L 51/54

(54) **Organic electroluminescent device and display device**

(30) Priority: 13.06.2007 JP 2007156747
(71) Applicant: Fuji Xerox Co., Ltd., Minato-ku Tokyo (JP)
(72) Inventor: Okuda, Daisuke c/o Fuji Xerox Co., Ltd., Ashigarakami-gun, Kanagawa (JP); Sata, Katsuhiro c/o Fuji Xerox Co., Ltd., Kanagawa (JP); Nishino, Yohei c/o Fuji Xerox Co., Ltd., Kanagawa (JP); Horiba, Koji c/o Fuji Xerox Co., Ltd., Kanagawa (JP); Mashimo, Kiyokazu c/o Fuji Xerox Co., Ltd., Kanagawa (JP); Agata, Takeshi c/o Fuji Xerox Co., Ltd., Kanagawa (JP); Ishii, Toru c/o Fuji Xerox Co., Ltd., Ashigarakami-gun, Kanagawa (JP); Imai, Akira c/o Fuji Xerox Co., Ltd., Ashigarakami-gun, Kanagawa (JP); Ozaki, Tadayoshi c/o Fuji Xerox Co., Ltd., Kanagawa (JP); Hirose, Hidekazu c/o Fuji Xerox Co., Ltd., Kanagawa (JP); Yoneyama, Hirohito c/o Fuji Xerox Co., Ltd., Kanagawa (JP); Seki, Mieko c/o Fuji Xerox Co., Ltd., Kanagawa (JP)
(74) Representative: Jones, Helen M.M.

(57) **Abstract**

The invention provides an organic electroluminescent device having an electrode pair of an anode and a cathode, at least one of which is transparent or translucent, and an organic compound layer disposed between the anode and the cathode, the organic compound layer having two or more layers including a buffer layer and a light-emitting layer. At least one of the layers of the organic compound layer has a specific charge-transporting polyether. The buffer layer is provided in contact with the anode and having at least a crosslinked compound formed by using at least one charge injection material having a specific substituted silicon group. The invention further provides a display device having at least a substrate, plural organic electroluminescent devices disposed on the substrate in a matrix form, and a driving unit to drive the organic electroluminescent devices, each of the plural organic electroluminescent devices is the organic electroluminescent device.

## Description

### BACKGROUND

### Technical Field

The present invention relates to an organic electroluminescent (EL) device and a display device.

### Related Art

Electroluminescent devices, selfluminous all-solid-state devices that are more visible and resistant to shock, are expected to find wider application.

Researches on electroluminescent devices by using organic compounds started with a single crystal such as that of anthracene. Further, researches on electroluminescent devices having thinner films formed by vacuum-deposition are also started (Thin Solid Films, 94 (1982) pp. 171-183).

Recently, a function-separated laminated-film organic electroluminescent device which has a layer of aromatic diamine and a layer of Alq₃ sequentially laminated in this order and gives a high brightness of 1,000 cd/m² or higher at a low voltage of approximately 10 V has been reported (Appl. Phys. Lett. Vol. 51 (1987) pp. 913-915), and since that research and development on such laminated electroluminescent devices have been in progress intensively.

Such a laminated-film device gives high-brightness emission, while holes and electrons are injected from electrodes through a charge-transporting layer of a charge-transporting organic compound into a light-emitting layer of a fluorescent organic compound and the holes and electrons injected and trapped into the light-emitting layer recombined to each other while the carrier balance between the hole and the electron is maintained.

An organic electroluminescent devices formed using a starburst amine that forms a stable amorphous glass state as a hole-transporting material to suppress generation of Joule heat upon driving of the devices (Proceedings of the 40th Applied Physics Related Associated Seminar, 30a-SZK-14 (1993)), an organic electroluminescent device formed using a polymer polyphosphazenes having triphenylamines in the side chains (Polymer Preprints, Japan, Vol. 42, No. 7, 20J-21 (1993)) have been also reported.

Research and development on single layer electroluminescent devices have also been in progress in view of reducing processing time lengths, and a device formed using conducting polymers such as poly (p-phenylene vinylene) (Nature, Vol. 357 (1992) pp. 477-479), an organic electroluminescent device having an emitting layer formed using a solution containing hole transporting-polyvinylcarbazole mixed with an electron transporting material and a fluorescence dye (Proceedings of the 3 8th Applied Physics Related Associated Seminar, 31p-G-12 (1991)) and the like have been reported.

Further, from the viewpoint of methods for manufacturing electroluminescent devices, researches for a wet application process are in progress in view of simplification of manufacturing process, processing suitability, upsizing and costs. There have been reported organic electroluminescent devices formed by a casting method (Proceedings of the 50th Applied Physics Society Seminar, 29p-ZP-5 (1989) and Proceedings of the 51th Applied Physics Society Seminar, 28a-PB-7 (1990)).

Display devices using an organic electroluminescent device are more suited for reduction in size and thickness than other display devices such as liquid crystal, and would be used more widely in portable devices driven by an internal power supply. It is important to make the device operate for a longer period with lower power consumption for use in such a portable device.

On the other hand, organic electroluminescent devices commonly have a basic layer structure composed of an ITO transparent electrode (anode), a hole-transporting layer (or light-emitting layer having a charge-transporting potential) provided thereon, and other layers provided as needed. For use in the applications described above and for energy conservation, known is a method of providing a buffer layer between the transparent electrode and the hole-transporting layer (or light-emitting layer having a charge-transporting potential) and thus, improving the charge (hole) injection efficiency into the hole-transporting layer (or light-emitting layer having a charge-transporting potential), and it is possible to reduce the driving voltage by the method. Examples of the materials for the buffer layer include PEDOT (polyethylene-dioxythiophene), star-burst amines, CuPc (copper phthalocyanine), and the like.

### SUMMARY

According to a first exemplary embodiment of a first aspect of the present invention, there is provided an organic electroluminescent device comprising an electrode pair of an anode and a cathode, at least one of which is transparent or translucent, and an organic compound layer disposed between the anode and the cathode,
the organic compound layer comprising two or more layers including at least a buffer layer and a light-emitting layer;
at least one of the layers of the organic compound layer comprising at least one charge-transporting polyether represented by the following Formula (I); and
the buffer layer being provided in contact with the anode and comprising a crosslinked compound formed by using at least one charge injection material having a substituted silicon group represented by the following Formula (III): 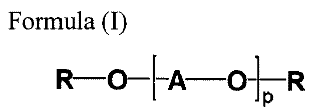 in Formula (I), A represents at least one structure represented by the following Formula (II-1) or (II-2); R represents a hydrogen atom, an alkyl group, a substituted or unsubstituted aryl group, a substituted or unsubstituted aralkyl group, an acyl group, or a group represented by -CONH-R', in which R' represents a hydrogen atom, an alkyl group, a substituted or unsubstituted aryl group, or a substituted or unsubstituted aralkyl group; and p is an integer of 5 to 5,000, 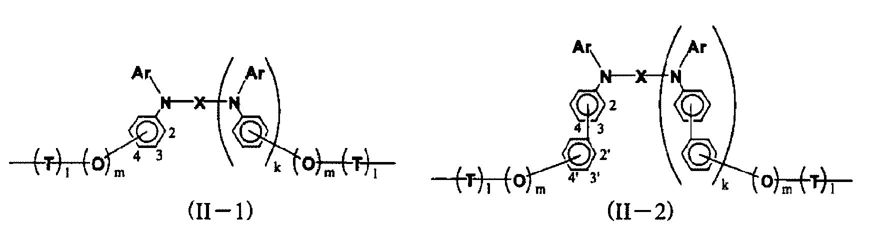 in Formulae (II-1) and (I-2), Ar represents a substituted or unsubstituted monovalent aromatic group; X represents a substituted or unsubstituted divalent aromatic group; k, m, and 1 each is 0 or 1; T represents a divalent straight-chain hydrocarbon having 1 to 6 carbon atoms or a branched hydrocarbon having 2 to 10 carbon atoms, and 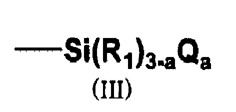 in Formula (III), R₁ represents a hydrogen atom, an alkyl group, or a substituted or unsubstituted aryl group; Q represents a hydrolyzable group; and a is an integer of 1 to 3.

According to an exemplary embodiment of a second aspect of the present invention, there is provided an display device comprising: a substrate; a plurality of the organic electroluminescent devices disposed on the substrate and arranged in a matrix form; and a driving unit to drive the organic electroluminescent devices, each of the organic electroluminescent devices being the organic electroluminescent device of any one of the first to tenth exemplary embodiments of the first aspect of the present invention.

### Brief Description of the Drawings

Figure 1 is a schematic sectional view illustrating an exemplary embodiment of layer structure of organic electroluminescent device of the present invention;
Figure 2 is a schematic sectional view illustrating another exemplary embodiment of layer structure of organic electroluminescent device of the present invention;
Figure 3 is a schematic sectional view illustrating another exemplary embodiment of layer structure of organic electroluminescent device of the present invention; and
Figure 4 is a schematic sectional view illustrating another exemplary embodiment of layer structure of organic electroluminescent device of the present invention.

### Detailed Description

Hereinafter, exemplary embodiments of the invention will be described in detail.

The organic electroluminescent device in the exemplary embodiment has an anode and a cathode, at least one of which is transparent or translucent, and an organic compound layer disposed between the anode and the cathode. The organic compound layer has at least two or more layers including at least a buffer layer and a light-emitting layer. At least one of the layers of the organic compound layer has at least one charge-transporting polyether represented by Formula (I). Further, the buffer layer is provided in contact with the anode and has at least a crosslinked compound formed by using at least one charge injection material having a substituted silicon group represented by Formula (III).

The organic electroluminescent device in the configuration of the exemplary embodiment is superior in brightness, stability and durability and easier to produce, allows expansion of the device area, gives a smaller number of defects during production, and shows smaller deterioration in device performance with time. It is based on the results of the studies described below.

The inventors have studied intensively the reasons for various defects during production for an organic electroluminescent device provided with the buffer layer and also for deterioration in device performance with time. They have also studied the problems in forming a hole-transporting layer or a light-emitting layer having a charge-transporting potential on the surface of a buffer layer formed on an anode (hereinafter, a layer formed directly or indirectly via another layer on the buffer layer will be referred to as "neighboring layer") by using a polymeric charge-transporting material.

As a result, it was confirmed that, when the charge-transporting polymer used was a polymer having a vinyl skeleton (see, e.g., PTPDMA (Jap. J. Polymer Sci. Tech., Vol. 52, 216 (1995)) or a polymer having a polycarbonate skeleton (see, e.g., Et-TPAPEK (Preprint of 43rd Conference of Applied Physics-related Societies, 27a-SY-19, pp. 1, 126 (1996)), the buffer layer was less adhesive to the neighboring layer, causing defect of exfoliation and generation of pinholes and aggregation. The reasons for the defects seemed incompatibility between the buffer layer and the neighboring layer at the interface and lacking of flexibility of the polymer constituting the neighboring layer.

Therefore, the inventors have considered that, for prevention of defects during film formation, it would be effective to make the charge-transporting polymer for use in forming the neighboring layer more molecularly flexible or to allow reorganization among molecules in the neighboring layer by using a material having a high-flexibility molecular structure, or by reducing the size of molecule (reduction in molecular weight) even if a material having a low-flexibility molecular structure described above is used.

The reasons for deterioration in device performance with time were also studied. As a result, it was found that, if the charge-transporting polymer used has a vinyl skeleton or polycarbonate skeleton similarly to those described above, it caused increase in driving voltage and power consumption with time and further deterioration in the emitting characteristics.

Further studies on the reasons revealed that a low-molecular weight component contained in the buffer layer (e.g., star-burst amine or CuPc (copper phthalocyanine) or the counter ion of an ionic substance used in combination with PEDOT (polyethylene-dioxythiophene)) bled (exudated) into the neighboring layer with the passage of time by electric field or the Joule's heat generated when electric field is applied to the device, prohibiting the function inherent to the neighboring layer. The bleeding indicates that the low-molecular weight component in the buffer layer readily permeates into the neighboring layer formed by using a charge-transporting polymer having a vinyl- or polycarbonate-skeleton, in other words that there is a greater/easily-formed gap between the charge-transporting polymers in the neighboring layer.

Accordingly, the inventors have considered it important to form a dense, highly heat-resistant neighboring layer for prevention of bleeding of the low-molecular weight component into the neighboring layer. In such a case, it is important for prevention of bleeding to reduce the gap between molecules facilitating bleeding of low-molecular weight components during formation of the neighboring layer and to prevent relative migration of molecules in the neighboring layer once formed and generation of the intermolecular gap under heat.

Accordingly, it is needed for prevention of bleeding to use a material having a molecular structure superior in heat resistance (glass transition temperature), flexibility and closeness as the charge-transporting polymer for forming the neighboring layer. However, the condition has an antinomic relationship with the use of a charge-transporting polymer having a molecular structure lower in flexibility, an option in preventing generation of the defects during film formation.

Alternatively for drastic prevention of bleeding, it would be effective to use a material containing no low-molecular weight component causing bleeding as the charge injection material or an additive thereto used in forming the buffer layer.

In addition, the charge-transporting polymer should have a certain number of hopping sites for charge transfer in the molecule, for assurance of high charge mobility, which is critical for favorable emitting characteristics of the organic electroluminescent device. In other words, the polymer should have a molecule size (molecular weight) of a particular value or more. However, the condition is also antinomic with the use of a low-molecular-weight charge-transporting polymer having a structure lower in flexibility, an option in preventing generation of defects during film formation, similarly to the case of bleed control.

It is essentially difficult to form a dense neighboring layer for prevention of bleeding with a charge-transporting polymer having a less flexible molecular structure, and thus, such a polymer has a dilemma that is difficult to overcome that reduction in the molecular weight for prevention of bleeding leads to deterioration in heat resistance, and consequently to acceleration of bleeding and deterioration in charge mobility which affects the entire basic characteristics of the device.

For assuring the basic emitting characteristics and from the points of processability and practical utility during long-term use, the inventors considered that, in preparing an organic electroluminescent device provided with a buffer layer, it was important to use a material in the molecular structure sufficiently higher in charge mobility, higher in flexibility and closeness, and higher in heat resistance as the charge-transporting polymer for forming the neighboring layer when a bleed-causing material is used for the buffer layer.

The charge-transporting polyether has the following characteristics:
(1) The ether bond connecting functional sites to each other is a strong bond and resistant to deformation.
(2) The polyether has its polar group in the main chain, and thus, the influence thereof on charge transport is smaller than that having the polar group on the side chain. Further, addition of a spacer is effective in reducing the influence of the polar group.
(3) The polyether is superior in adhesiveness to the neighboring layer (in particular, buffer layer) with its polar ester bond group.
For that reasons above, it is desirable to use polyether having its functional units incorporated in the main chain as the charge-transporting polymer.

For drastic prevention of bleeding, it would be needed to form the buffer layer with a component essentially demanding no bleed-causing low-molecular weight component, and thus, for example, the charge injection material is preferably formed not in the state containing low-molecular weight compounds, but formed with a material forming strong bonds in a network structure.

The material forming a network structure (network) is, for example, a three-dimensionally crosslinking material, and specific examples thereof for the charge injection material include:
(A) charge-transporting polyethers having a particular repetition structure and a hydroxyl or carboxyl group at the terminal and polycarbonates crosslinked with a crosslinking agent having three or more functional isocyanate or epoxy groups in the molecule (see, JP-A Nos. 8-176293, 8-208820, 8-253568, and 9-110974, and others);
(B) crosslinked charge-transporting materials having a heat- or photo-curable functional group at the terminal (see JP-A Nos. 2000-147804 and 2000-147813, and others);
(C) photo-crosslinked oxetane-containing charge transporting materials (see Macromol. Rapid Commun., 20, pp. 224-228 (1999)); and
(D) heat-crosslinked charge transporting materials having a alkoxysilyl group at the terminal (see Adv. Mater., Vol.11, No.2, pp. 107-112 (1999), Adv. Mater., Vol.11, No.9, pp. 730-734 (1999), JP-A Nos. 9-124665 and 11-38656, and others), and the like.

The buffer layer formed by three-dimensional crosslinking of the charge injection material containing substituted silicon group causes a crosslinking reaction with the substituted silicon group represented by Formula (III) described below, forming three dimensional -Si-O-Si- bonds, i.e., an effective inorganic glassy network structure (network), and such a product is superior in adhesiveness to a mainly inorganic substrate. Thus, the three-dimensional crosslinking is favorable, because it gives strong bonds and increases the adhesiveness to an anode mainly made of an inorganic material, and improves the properties of the organic electroluminescent device. In addition, use of the charge injection material represented by Formula (IV-1) to (IV-4) described below introduces an aromatic amine structural unit in the three-dimensional crosslinked structure, giving favorable injection efficiency in the neutral state without need for improvement in conductivity by using the doping effect by combined use of an electron-accepting material, and thus, allowing prevention of the bleeding to the neighboring organic compound layer, differently from the case when an electron-accepting material is blended as an additive.

Thus, it is possible to produce an organic EL device that is resistant to bleeding of the charge injection material into neighboring layer and superior in adhesiveness to the anode by use of the buffer layer above, that has a charge mobility sufficient for organic EL device because of a neighboring organic layer formed with the charge-transporting polyether, and thus, that is lowered in the number of defects such as pinhole and aggregation, superior in adhesiveness to the buffer layer, and thus, higher in performance for use in a longer period of time.

It is possible to form the organic compound layer in wet process, by using the polymeric compound in all materials for the organic compound layers in manufacturing process of the device, and such a process is advantageous from the points of simplification of production, processability, increase in device area size, cost, and others, and the charge-transporting polyether allows expression of stabilized device characteristics, independently of the kind of the emitting material used for the light-emitting layer.

As a result, the organic EL device of the exemplary embodiment is superior in brightness, stability and durability and easier to produce, allows increase in device area size, gives a smaller number of defects during production, and shows smaller deterioration in device performance with time.

Hereinafter, the charge-transporting polyether represented by Formula (I) will be described.

The charge transporting polyether has stronger and more flexible binding sites than other kinds of polyether, so that the molecular structure thereof has flexibility and high heat resistance (glass transition temperature). Accordingly, it is a material having excellent thin-film forming properties, facilitating the use of a wet film forming process, and having excellent durability.

As will be described below, it is possible to give the charge-transporting polyether any function, hole-transporting property or electron-transporting property, by proper selection of its molecular structure. For that reason, the polyester may be used for any layer, for example for a hole-transporting layer, a light-emitting layer, or a charge-transporting layer (carrier transport layer), according to application.

The charge-transporting polyether is particularly preferably a polyether having a hole-transporting capacity (hole-transporting polyether).

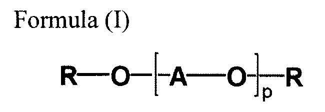

In Formula (I), A represents at least one structure selected from the structures represented by the following Formulae (II-1) and (II-2); R represents a hydrogen atom, an alkyl group, a substituted or unsubstituted aryl group, a substituted or unsubstituted aralkyl group, an acyl group, or a group represented by -CONH-R' wherein R' represents a hydrogen atom, an alkyl group, a substituted or unsubstituted aryl group, or a substituted or unsubstituted aralkyl group; and p is an integer of 5 to 5,000 .

In Formula (I), A represents at least one structure selected from the structures represented by the following Formulae (II-1) or (II-2); and two or more structures A may be present in one polymer.

The structures represented by the following Formulae (II-1) and (II-2) will be described in detail.

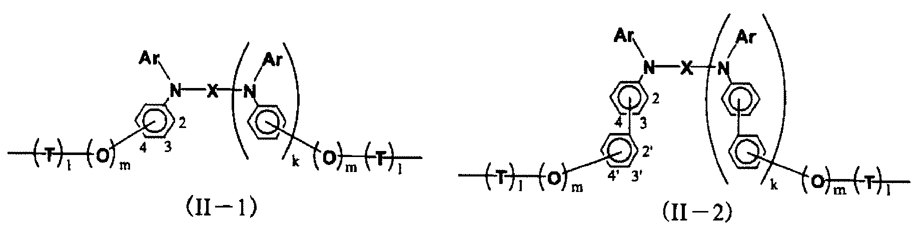

In Formulae (II-1) and (II-2), Ar represents a substituted or unsubstituted monovalent aromatic group; X represents a substituted or unsubstituted divalent aromatic group; k, m, and 1 each are 0 or 1; and T represents a divalent straight-chain hydrocarbon group having 1 to 6 carbon atoms or a branched hydrocarbon group having 2 to 10 carbon atoms.

In Formulae (II-1) and (II-2), Ar represents a substituted or unsubstituted monovalent aromatic group.
Specifically, Ar represents a substituted or unsubstituted phenyl group, a substituted or unsubstituted monovalent polynuclear aromatic hydrocarbon having 2 to 10 aromatic rings, a substituted or unsubstituted monovalent condensed ring-aromatic hydrocarbon having 2 to 10 aromatic rings, a substituted or unsubstituted monovalent aromatic heterocyclic ring, or, a substituted or unsubstituted monovalent aromatic group having at least one aromatic heterocyclic ring.

In Formulae (II-1) and (II-2), while the number of the aromatic rings constituting the polynuclear aromatic hydrocarbon and the condensed ring-aromatic hydrocarbon selected as the structure represented by Ar is not particularly limited, it is preferably 2 to 5, and the condensed ring-aromatic hydrocarbon is preferably an all-condensed ring-aromatic hydrocarbon. In the exemplary embodiment, the polynuclear aromatic hydrocarbon and the condensed ring-aromatic hydrocarbon are specifically the polycyclic aromatic compounds as defined below.

The "polynuclear aromatic hydrocarbon" is a hydrocarbon compound having two or more aromatic rings composed of carbon and hydrogen that are bound to each other by a carbon-carbon single bond. Specific examples thereof include biphenyl, terphenyl and the like.

Alternatively, the "condensed ring-aromatic hydrocarbon" is a hydrocarbon compound having two or more aromatic rings composed of carbon and hydrogen that are bound to each other via a pair of two or more carbon atoms nearby connected to each other. Specific examples thereof include naphthalene, anthracene, phenanthrene, fluorene and the like.

The "aromatic heterocyclic ring" represents an aromatic ring containing an element other than carbon and hydrogen. The number of atoms constituting the ring skeleton (Nr) is preferably 5 and/or 6. The kinds and the number of the elements other than C (foreign elements) constituting the ring skeleton is not particularly limited, however the element is preferably, for example, S, N, or O, and two or more kinds of and/or two or more foreign atoms may be contained in the ring skeleton. In particular, heterocyclic rings having a five-membered ring structure, such as thiophene, thiofin and furan, a heterocyclic ring substituted with nitrogen at the 3- and 4-positions thereof, pyrrole, or a heterocyclic ring further substituted with nitrogen at the 3- and 4-positions, are used preferably, and heterocyclic rings having a six-membered ring structure such as pyridine are also used preferably.

The "aromatic group containing an aromatic heterocyclic ring" is a binding group having at least such an aromatic heterocyclic ring in the atomic group constituting the skeleton. The group may be an entirely conjugated system or a system at least partially non-conjugated, however an entirely conjugated system is favorable from the points of charge-transporting property and luminous efficiencies.

Examples of the substituents on the phenyl group, polynuclear aromatic hydrocarbon, condensed ring-aromatic hydrocarbon, aromatic heterocyclic ring, or aromatic group containing an aromatic heterocyclic ring include a hydrogen atom, alkyl groups, alkoxy groups, a phenoxy group, aryl groups, aralkyl groups, substituted amino groups, halogen atoms and the like.

The alkyl group preferably has 1 to 10 carbon atoms, and examples thereof include a methyl group, an ethyl group, a propyl group, an isopropyl group and the like. The alkoxyl group preferably has 1 to 10 carbon atoms, and examples thereof include a methoxy group, an ethoxy group, a propoxy, and an isopropoxy group. The aryl group preferably has 6 to 20 carbon atoms, and examples thereof include a phenyl group and a tolyl group. The aralkyl group preferably has 7 to 20 carbon atoms, and examples thereof include a benzyl group and a phenethyl group. The substituent groups on the substituted amino group include an alkyl group, an aryl group and an aralkyl group, and specific examples thereof include those described above.

In Formulae (II-1) and (II-2), X represents a substituted or unsubstituted divalent aromatic group. Specific examples of the group X include substituted or unsubstituted phenylene groups, substituted or unsubstituted divalent polynuclear aromatic hydrocarbons having 2 to 10 aromatic rings, substituted or unsubstituted divalent condensed ring-aromatic hydrocarbons having 2 to 10 aromatic rings, substituted or unsubstituted divalent aromatic heterocyclic rings, and substituted or unsubstituted divalent aromatic groups containing at least one aromatic heterocyclic ring.

The "polynuclear aromatic hydrocarbon", the "condensed ring-aromatic hydrocarbon", the "aromatic heterocyclic ring", and the "aromatic group containing an aromatic heterocyclic ring" are the same as those described above.

In Formulae (II-1) and (II-2), k, 1, and m are 0 or 1; T represents a divalent straight-chain hydrocarbon group having 1 to 6 carbon atoms or a divalent branched hydrocarbon group having 2 to 10 carbon atoms, and is preferably represents a group selected from a divalent straight-chain hydrocarbon group having 2 to 6 carbon atoms and a divalent branched hydrocarbon groups having 3 to 7 carbon atom. Specific structures of T are shown below.

-CH=CH-, -CH=CH-CH=CH-, -CH₂-CH=CH-CH₂-, -CH₂-, -(CH₂)₂-, -(CH₂)₃-, -(CH₂)₄-, -(CH₂)₆-, -(CH₂)₆-,

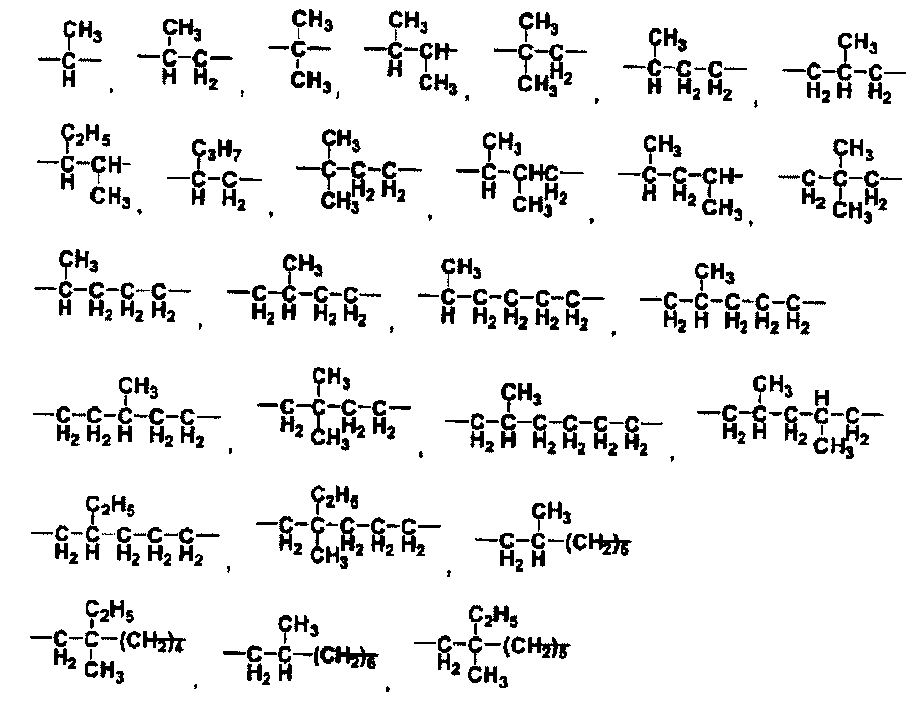

Hereinafter, the charge-transporting polyether represented by Formula (I) will be described in detail.

In Formula (I), R represents a hydrogen atom, an alkyl group, a substituted or unsubstituted aryl group, a substituted or unsubstituted aralkyl group, an acyl group or a group represented by -CONH-R'.

The alkyl group preferably has 1 to 10 carbon atoms, and examples thereof include a methyl group, an ethyl group, a propyl group, and an isopropyl group. The aryl group preferably has 6 to 20 carbon atoms, and examples thereof include a phenyl group and a tolyl group. The aralkyl group preferably has 7 to 20 carbon atoms, and examples thereof include a benzyl group and a phenethyl group. Examples of the substituent group(s) on the substituted aryl group or the substituted aralkyl group include a hydrogen atom, an alkyl group, an alkoxy group, a substituted amino group, a halogen atom, and the like.

The acyl group is not particularly limited and may be any group expressed by RCO-, however, preferable examples include an acetyl group, a propionyl group, a malonyl group, and a benzoyl group.

R' in the group -CONH-R' represents a hydrogen atom, an alkyl group, a substituted or unsubstituted aryl group, or a substituted or unsubstituted aralkyl group. R' in the group -CONH-R' may be specifically as follows: an alkyl group that is preferably linear or branching, having 1 to 10 carbon atoms, and preferable examples thereof include a methyl group, an ethyl group, and an isopropyl group; an aryl group that preferably has 6 to 20 carbon atoms, and preferable examples thereof include a phenyl group and a tolyl group; an aralkyl group that is a lower alkyl group substituted with an aryl group, with the aryl group being the same as described above, and specific examples of the aryl group including a benzyl group, a phenylethyl group, a phenylpropyl group, a naphthylmethyl group, and a naphthylethyl group.

In Formula (I), p indicates a polymerization degree in the range of 5 to 5,000, which preferably indicates in the range of 10 to 1,000.

The weight average molecular weight Mw of the charge-transporting polyether is preferably in the range of 5,000 to 1,000,000, and is more preferably in the range of 10,000 to 300,000.

The weight average molecular weight Mw can be determined by the following method.
he weight-average molecular weight is determined, by first preparing a 1.0 % by weight charge-transporting polyether THF (tetrahydrofuran) solution and analyzing the solution by gel penetration chromatography (GPC) by using a differential refractometer (RI, manufactured by TOSOH corp., trade name: UV-8020) while styrene polymers is used as calibration samples.

From the points of processability and basic physical properties satisfying the device characteristics, it is preferable that: in Formulae (I-1) and (I-2), R preferably represents a methyl or an ethyl group; and p is preferably an integer of 10 to 1,000; and in Formula (II-1) and (II-2) represented by A, Ar preferably represents a phenyl group, a biphenyl group, a naphthalene group, or a 9,9'-dimethylfluorene group (the substituent group of the aromatic ring is preferably a methyl group, an ethyl group, an isopropyl group, a tert-butyl group, or a methoxy group); X preferably represents a group represented by the following Formula (19) or (20);

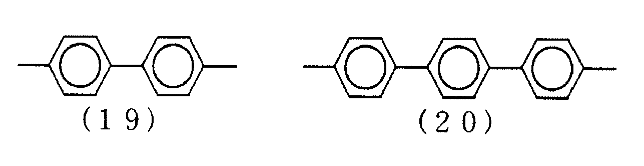

k is preferably 1; m is 0; 1 is preferably 1; and T preferably represents a methylene group or a dimethylene group.

Specific examples of the charge-transporting polyethers represented by Formulae (I-1) and (I-2) include those disclosed in Japanese Patent Nos. 2,894,257, 2,865,020, 2,865,029, 3,267,115 and 3,058,069, and others.

Specific examples of the charge-transporting polyether represented by Formula (I) include those described in any one of JP-A Nos. 2002-75654, 2002-313576, 2004-87395, 2004-199998, and 2005-235645.

Hereinafter, the method of preparing the charge-transporting polyether will be described. The charge-transporting polyether is prepared by polymerizing a charge-transporting monomer represented by the following Formula (V-1) or (V-2) by a known method such as that described in New Experimental Chemistry, 4th Ed., No. 28 (Maruzen, 1992).

In Formulae (V-1) and (V-2), A' represents a hydroxyl group, a halogen atom, an alkoxyl group [-OR₁₃, wherein R₁₃ represents an alkyl group (e.g., methyl group, ethyl group)]; and Ar, X, T, k, l, and m are the same as those in Formula (II-1) or (II-2) above.

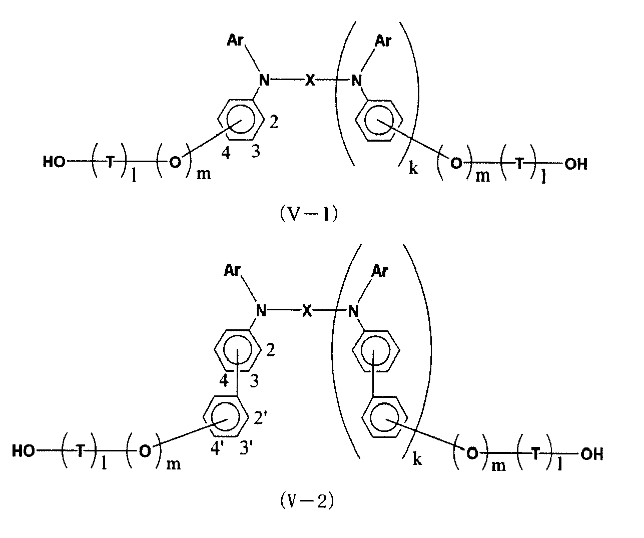

The charge-transporting polyether represented by Formula (I) can be prepared in any one of the following synthesis methods 1 to 3.

### Synthesis method 1

The charge transporting polyether is synthesized, for example, through dehydration condensation under heating of the charge transporting compound (charge transporting monomer) having two hydroxyalkyl groups expressed by Formula (V-1) or (V-2) (synthesis method 1).
In this case, the charge transporting monomer is preferably heat-melted with no solvent, thereby accelerating polymerization by water desorption under reduced pressure.
In cases where a solvent is used, water is effectively removed by a solvent which is capable of azeotropically boiling with water, such as trichloroethane, toluene, chlorobenzene, dichlorobenzene, nitrobenzene, or 1-chloronaphthalene. The amount of the solvent is preferably about 1 equivalent to about 100 equivalents, more preferably about 2 equivalents to about 50 equivalents per equivalent of the charge transporting monomer.
The reaction temperature is not particularly limited, however the reaction is preferably carried out at the boiling point of the solvent to remove water generated during polymerization. If the polymerization does not proceed, the solvent may be removed from the reaction system, and the monomer may be stirred under heating in a viscous state.

### Synthesis method 2

Alternatively, the charge transporting polyether may be synthesized through dehydration condensation with an acid catalyst, for example, a protonic acid such as p-toluenesulfonic acid, hydrochloric acid, sulfuric acid, or trifluoroacetic acid, or a Lewis acid such as zinc chloride (synthesis method 2). In this case, the amount of the acid catalyst is preferably about 1/10,000 equivalents to about 1/10 equivalents, more preferably about 1/1,000 equivalents to about 1/50 equivalents per equivalent of the charge transporting monomer.
In order to remove water generated during polymerization, it is preferable to use a solvent capable of azeotropically boiling with water. Examples of effective solvents include toluene, chlorobenzene, dichlorobenzene, nitrobenzene, and 1-chloronaphthalene. The amount of the solvent is preferably about 1 equivalent to about 100 equivalents, more preferably about 2 equivalents to about 50 equivalents of the charge transporting monomer.
The reaction temperature is not particularly limited, however the reaction is preferably carried out at the boiling point of the solvent to remove water generated during polymerization.

### Synthesis method 3

Alternatively, the charge transporting polyether may be synthesized using a condensing agent such as, for example: an alkyl isocyanide such as cyclohexyl isocyanide; an alkyl cyanide such as cyclohexyl cyanide; a cyanate ester such as p-tolyl cyanate or 2,2-bis(4-cyanatephenyl)propane; dichlorohexyl carbodiimide (DCC); or trichloroacetonitrile (synthesis method 3). In this case, the amount of the condensing agent is preferably about 1/2 equivalent to about 10 equivalents, more preferably about 1 equivalent to about 3 equivalents per equivalent of the charge transporting monomer.
Examples of effective solvents include toluene, chlorobenzene, dichlorobenzene, and 1-chloronaphthalene. The amount of the solvent is preferably about 1 equivalent to about 100 equivalents, more preferably about 2 equivalents to about 50 equivalents per equivalent of the charge transporting monomer.
The reaction temperature is not particularly limited, however the reaction is preferably carried out, for example, at a temperature from room temperature (for example 25°C) to the boiling point of the solvent.

Among the synthesis methods 1, 2, and 3, the synthesis methods 1 or 3 are preferable from the viewpoint that they do not readily undergo isomerization or side reactions. In particular, the synthesis method 3 is more preferable because of its mild reaction conditions.

After reaction, when no solvent is used, the mixture is dissolved in a good solvent. When a solvent is used, the reaction solution is added dropwise as it is, into a poor solvent for polymer such as alcohol (such as methanol or ethanol) or acetone, allowing precipitation of the charge-transporting polyether, and, after separation, the charge-transporting polyether is washed with water and an organic solvent thoroughly and dried. If needed, the reprecipitation processing may be repeated, by dissolving the polyether in a suitable organic solvent and adding the solution dropwise into a poor solvent, thus, precipitating the charge-transporting polyether.

During the reprecipitation processing, the reaction mixture is preferably stirred thoroughly, for example, with a mechanical stirrer.
The solvent for dissolving the charge-transporting polyether during the reprecipitation processing is preferably used in an amount in the range of 1 to 100 parts by weight, preferably in the range of 2 to 50 parts by weight, with respect to 1 part by weight of the charge-transporting polyether.
The poor solvent is used in an amount in the range of 1 to 1,000 parts by weight, preferably in the range of 10 to 500 parts by weight, with respect to 1 part by weight of the charge-transporting polyether.

In the reaction, a copolymer may be synthesized using two or more, preferably two to five, even more preferably two or three kinds of charge transporting monomers. Copolymerization with different kinds of charge transporting monomers allows the control of electrical properties, film-forming properties, and solubility.

The terminal group of the charge transporting polyether may be, in common with the charge transporting monomer, a hydroxyl group (in other words R in the formula (I) may be a hydrogen atom), however, the terminal group R may be modified to control the polymer properties such as solubility, film forming properties, and mobility.

For example, the terminal hydroxyl group of the charge transporting polyether may be alkyl-etherified with, for example, alkyl sulfate or alkyl iodide. Specific examples of the reagent for the alkyl etherification reaction include dimethyl sulfate, diethyl sulfate, methyl iodide, and ethyl iodide. The amount of the reagent is preferably about 1 equivalent to about 3 equivalents, more preferably about 1 equivalent to about 2 equivalents per equivalent of the terminal hydroxyl group. A base catalyst may be used for the alkyl etherification reaction. Examples of the base catalyst include sodium hydroxide, potassium hydroxide, hydrogenated sodium, and metallic sodium. The amount of the base catalyst is preferably about 0.9 equivalents to about 3 equivalents, more preferably about 1 equivalent to about 2 equivalents per equivalent of the terminal hydroxyl group.

The temperature of the alkyl etherification reaction is, for example, from 0°C to the boiling point of the solvent used. Examples of the solvent used for the alkyl etherification reaction include a single solvent or a mixed solvent composed of two to three kinds of solvents selected from inactive solvents such as benzene, toluene, methylene chloride, tetrahydrofuran, N,N-dimethylformamide, dimethyl sulfoxide, N-methylpyrrolidone, or 1,3-dimethyl-2-imidazolidinone.
As necessary, a quaternary ammonium salt such as tetra-n-butyl ammonium iodide may be used as a phase transfer catalyst.

The hydroxyl group at the terminal of the charge transporting polyether may be acylated using an acid halide (in other words R in the formula (I) may be an acyl group).
The acid halide is not particularly limited, and examples thereof include acryloyl chloride, crotonyl chloride, methacryloyl chloride, 2-furoyl chloride, benzoyl chloride, cyclohexanecarbonyl chloride, enanthyl chloride, phenylacetyl chloride, o-toluoyl chloride, m-toluoyl chloride, and p-toluoyl chloride. The amount of the acid halide is preferably about 1 equivalent to about 3 equivalents, more preferably about 1 equivalent to about 2 equivalents per equivalent of the terminal hydroxyl group.
A base catalyst may be used for the acylation reaction. Examples of the base catalyst include pyridine, dimethylamino pyridine, trimethylamine, and triethylamine. The amount of the base catalyst is preferably about 1 equivalent to about 3 equivalents, more preferably about 1 equivalent to about 2 equivalents per equivalent of the acid halide.

Examples of the solvent used for the acylation include benzene, toluene, methylene chloride, tetrahydrofuran, and methyl ethyl ketone.
The temperature of the acylation reaction may be, for example, from 0°C to the boiling point of the solvent used. The reaction temperature is preferably from 0°C to 30°C.

The acylation reaction may be carried out using an acid anhydride such as acetic anhydride. In cases where a solvent is used, the solvent may be specifically, for example, an inert solvent such as benzene, toluene, or chlorobenzene. The temperature of the acylation reaction with an acid anhydride is, for example, from 0°C to the boiling point of the solvent used. The reaction temperature is preferably from 50°C to the boiling point of the solvent used.

The terminal hydroxyl group of the charge transporting polyether may be alkyl etherified or acylated as described above, or a urethane residue may be introduced to the terminal using a monoisocyanate (in other words R in the formula (I) may be the group -CONH-R'). Specific examples of such a monoisocyanate include benzyl ester isocyanate, n-butyl ester isocyanate, t-butyl ester isocyanate, cyclohexyl ester isocyanate, 2,6-dimethyl ester isocyanate, ethyl ester isocyanate, isopropyl ester isocyanate, 2-methoxyphenyl ester isocyanate, 4-methoxyphenyl ester isocyanate, n-octadecyl ester isocyanate, phenyl ester isocyanate, isopropyl ester isocyanate, m-tolyl ester isocyanate, p-tolyl ester isocyanate, and 1-naphthylester isocyanate. The amount of the monoisocyanate is preferably about 1 equivalent to about 3 equivalent, more preferably about 1 equivalent to about 2 equivalents per equivalent of the terminal hydroxyl group.

Examples of the solvent used for the introduction of a urethane residue include benzene, toluene, chlorobenzene, dichlorobenzene, methylene chloride, tetrahydrofuran, N,N-dimethylformamide, dimethyl sulfoxide, N-methylpyrrolidone, and 1,3-dimethyl-2-imidazolidinone.

The reaction temperature for the introduction of a urethane residue is, for example, from 0° to the boiling point of the solvent used. If the reaction does not readily proceed, a catalyst may be added. Examples of the catalyst include a metal compound such as dibutyltin (II) dilaurate, octyltin (II), or lead naphthenate, or a tertiary amine such as triethylamine, trimethylamine, pyridine, or dimethylaminopyridine.

Hereinafter, the charge injection material having a substituted silicon group represented by Formula (III) will be described.

The charge injection material having a substituted silicon group is represented by Formula (III), and has, for example, a substituted silicon group having a hydrolyzable group, is a three-dimensionally crosslinking material that causes a crosslinking reaction, forming three dimensional -Si-O-Si- bonds, i.e., an inorganic glassy mesh structure (network).

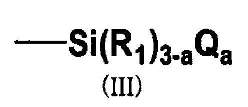

In Formula (III), R₁ represents a hydrogen atom, an alkyl group, or a substituted or unsubstituted aryl group. Q represents a hydrolytic group. a is an integer of 1 to 3 .

In Formula (III), the alkyl group represented by R₁ is, for example, an alkyl group having 1 to 10 carbon atoms, and examples thereof include a methyl group, an ethyl group, a propyl group, and an isopropyl group.

In Formula (III), the aryl group represented by R₁ preferably has 6 to 20 carbon atoms, and examples thereof include a phenyl group and a tolyl group. The substituent groups of the aryl group include an alkyl group, an alkoxy group, a phenoxy group, an aryl group, an aralkyl group, a substituted amino group, a halogen atom and the like.

The alkyl group as the substituent group on the aryl group represented by R₁ is preferably an alkyl group having 1 to 10 carbon atoms, and examples thereof include a methyl group, an ethyl group, a propyl group, an isopropyl group and the like. The alkoxyl group as the substituent group on the aryl group represented by R₁ preferably has 1 to 10 carbon atoms, and examples thereof include a methoxy group, an ethoxy group, a propoxy group, an isopropoxy group and the like. The aryl group as the substituent group on the aryl group represented by R₁ preferably has 6 to 20 carbon atoms, and examples thereof include a phenyl group, a tolyl group and the like. The aralkyl group as the substituent group on the aryl group represented by R₁ preferably has 7 to 20 carbon atoms, and examples thereof include a benzyl group, a phenethyl group and the like. The substituent groups of the substituted amino group as the substituent group on the aryl group represented by R₁ include an alkyl group, an aryl group, an aralkyl group and the like, and specific examples are the same as those described for Formula (I).

Examples of the hydrolytic group represented by Q include an alkoxy group, a methylethylketoxime group, a diethylamino group, an acetoxy group, a propenoxy group, a halogen atom and the like. The alkoxy group preferably has 1 to 10 carbon atoms, and examples thereof include a methoxy group, an ethoxy group, a propoxy group, an isopropoxy group and the like.

Specific examples of the charge injection material having a substituted silicon group represented by Formula (III) include aromatic compounds such as tetraphenylenediamine compounds, triphenylamine compounds, carbazole compounds, stilbene compounds, and arylhydrazone compounds. Among them, aromatic amine compounds represented by any one of the following Formulae (IV-1) to (IV-4) are preferable.

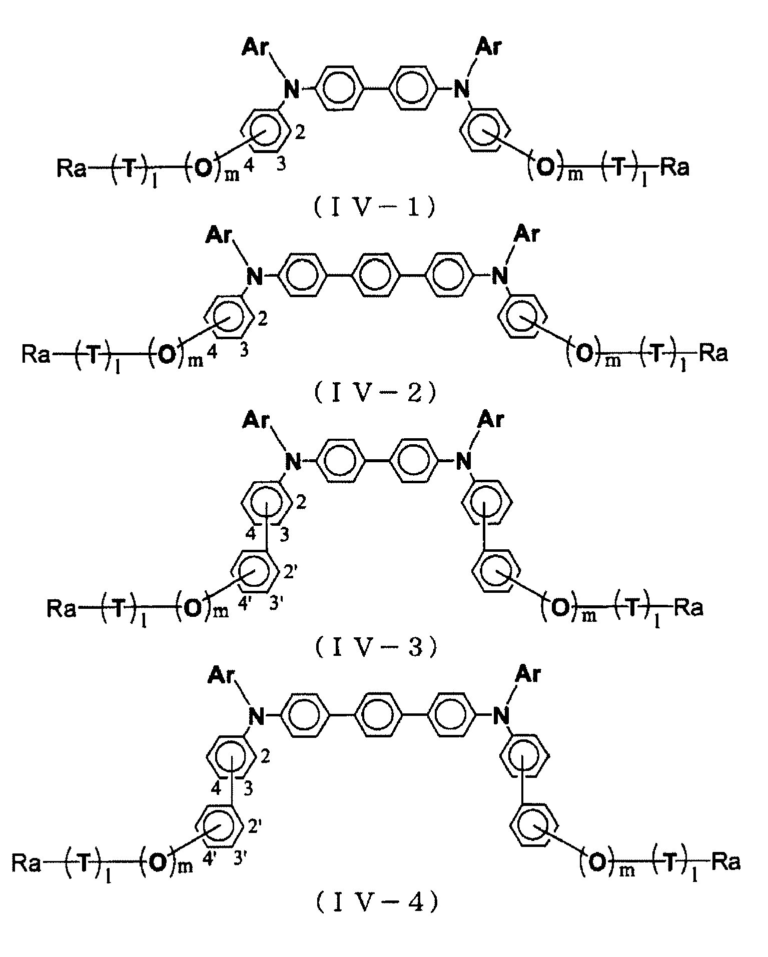

In Formulae (IV-1) to (IV-4), Ar represents a substituted or unsubstituted monovalent aromatic group; Ra represents at least one substituted silicon group represented by Formula (III); m and 1 are 0 or 1; and T represents a divalent straight-chain hydrocarbon having 1 to 6 carbon atoms or a branched hydrocarbon having 2 to 10 carbon atoms.

In Formulae (IV-1) to (IV-4), Ar represents a substituted or unsubstituted monovalent aromatic group. Specifically, Ar represents a substituted or unsubstituted phenyl group, a substituted or unsubstituted monovalent polynuclear aromatic hydrocarbon having 2 to 10 aromatic rings, a substituted or unsubstituted monovalent condensed ring-aromatic hydrocarbon having 2 to 10 aromatic rings, a substituted or unsubstituted monovalent aromatic heterocyclic ring, or, a substituted or unsubstituted monovalent aromatic group containing at least one aromatic heterocyclic ring.

The "polynuclear aromatic hydrocarbon", the "condensed ring-aromatic hydrocarbon", the "aromatic heterocyclic ring", and the "aromatic group containing an aromatic heterocyclic ring" are the same as those described above.

In Formula (IV-1) to (IV-4), 1 and m are 0 or 1; and T represents a divalent straight-chain hydrocarbon having 1 to 6 carbon atoms or a divalent branched hydrocarbon group having 2 to 10 carbon atoms, preferably a group selected from divalent straight-chain hydrocarbon groups having 2 to 6 carbon atoms and divalent branched hydrocarbon groups having 3 to 7 carbon atoms. Specific structures of T are the same as those described above.

The aromatic amine compounds described above represented by Formulae (IV-1) to (IV-4) have a substituted silicon group represented by Formula (III) via a covalent bond at the terminal, and are three-dimensionally crosslinking charge-transporting materials having the aromatic amine structural unit that can form a three-dimensionally crosslinked product.

The aromatic amine structures in Formulae (IV-1) and (IV-2) are biphenyl or terphenyl compounds of the regions represented by X in the structure represented by Formula (II-1), and the aromatic amine structures in Formulae (IV-3) and (IV-4) are biphenyl or terphenyl compounds of the region represented by X in Formula (II-2).

In the aromatic amine compounds represented by any one of Formulae (IV-1) to (IV-4), it is preferable that: Ar represents a phenyl group, a biphenyl group, a naphthalene group, or a 9,9'-dimethylfluorene group (the substituent group on the aromatic ring is preferably a methyl group, an ethyl group, an isopropyl group, a tert-butyl group, or a methoxy group); m is 0; 1 is 1; T represents a methylene group or a dimethylene group; and Ra represents -Si(OCH₃)₃ or -SiH(OCH₃)₂.

Specific examples of the aromatic amine compounds represented by Formula (IV-1) or (IV-2) include the followings.

**Table 1**

| No. | Ar | l | m | T | Ra | Binding site |
|---|---|---|---|---|---|---|
| 1. | 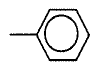 | 1 | 0 | -(CH₂)₂- | -Si(OCH₃)₃ | 4 |
| 2. | 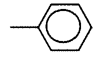 | 1 | 0 | -(CH₂)₂- | -Si(OCH₃)₃ | 3 |
| 3. | 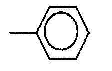 | 1 | 1 | -(CH₂)₂- | -Si(OCH₃)₃ | 4 |
| 4. | 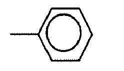 | 1 | 0 | -(CH₂)₂- | -SiH(OCH₃)₂ | 4 |
| 5. | 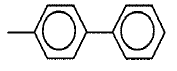 | 1 | 0 | -(CH₂)₂- | -Si(OCH₃)₃ | 4 |
| 6. | 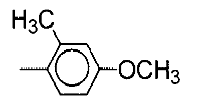 | 1 | 0 | -(CH₂)₂- | -Si(OCH₃)₃ | 4 |
| 7. | 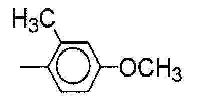 | 1 | 0 | -(CH₂)₂- | -SiH(OCH₃)₂ | 4 |
| 8. | 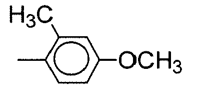 | 1 | 0 | -(CH₂)₂- | -Si(OC₂H₅)₃ | 4 |
| 9. | 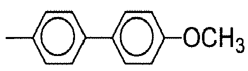 | 1 | 0 | -(CH₂)₂- | -Si(OCH₃)₃ | 4 |
| 10. | 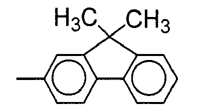 | 1 | 0 | -(CH₂)₂- | - Si(OCH₃)₃ | 4 |
| 11. | 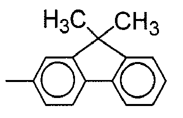 | 1 | 0 | -(CH₂)₂- | -SiH(OCH₃)₂ | 4 |
| 12. | 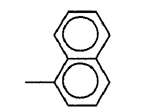 | 1 | 0 | -(CH₂)₂- | -Si(OCH₃)₃ | 4 |
| 13. | 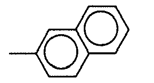 | 1 | 0 | -(CH₂)₂- | - Si(OCH₃)₃ | 4 |

Specific examples of the aromatic amine compounds represented by Formulae (IV-3) to (IV-4) include the followings:

**Table 2**

| No. | Ar | l | m | T | Ra | Binding site |
|---|---|---|---|---|---|---|
| 1. | 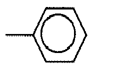 | 1 | 0 | -(CH₂)₂- | -Si(OCH₃)₃ | 4,4' |
| 2. | 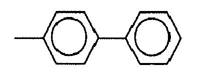 | 1 | 0 | -(CH₂)₂- | -Si(OCH₃)₃ | 4,4' |
| 3. | 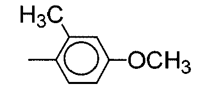 | 1 | 0 | -(CH₂)₂- | -Si(OCH₃)₃ | 4,4' |
| 4. | 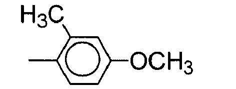 | 1 | 0 | -(CH₂)₂- | -S(OC₂H₅)₃ | 4,4' |
| 5. | 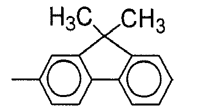 | 1 | 0 | -(CH₂)₂- | -(CH- Si(OCH₃)₃ | 4,4' |
| 6. | 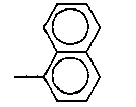 | 1 | 0 | -(CH₂)₂- | -(CH- Si(OCH₃)₃ | 4,4' |
| 7. | 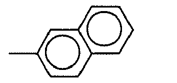 | 1 | 0 | -(CH₂)₂- | -Si(OCH₃)₃ | 4,4' |

Hereinafter, the layer structure of the organic electroluminescent device in the exemplary embodiment will be described in detail.
The organic electroluminescent device in the exemplary embodiment has a layer structure of electrodes of an anode and cathode at least one of which is transparent or translucent and an organic compound layer consisting of two or more layers including a light-emitting layer and a buffer layer disposed between the pair of electrodes. The buffer layer, which contains one or more charge injection materials substituted silicon group represented by Formula (III), is provided in contact with the anode. At least one of the organic compound layers other than the buffer layer contains at least one of the charge-transporting polyethers represented by Formula (I-1) or (I-2) above.
In addition, the organic compound layer located closest to the anode, among the organic compound layers having the charge-transporting polyether, has a film thickness preferably in the range of from equal to or approximately 20 nm to equal to or approximately 100 nm (more preferably from equal to or approximately 20 nm to equal to or approximately 80 nm, and still more preferably from equal to or approximately 20 nm to equal to or approximately 50 nm). The organic compound layer is preferably a light-emitting layer having a charge-transporting property when the organic compound layer is a single-layer. The organic compound layer is preferably a hole-transporting layer when it is a laminate having plural layers which are functionally separated.

In the organic electroluminescent device in the exemplary embodiment, when the organic compound layer is made only of a buffer layer and a light-emitting layer, the light-emitting layer means a light-emitting layer having a charge-transporting property, and the light-emitting layer having a charge-transporting property contains the charge-transporting polyether.

Alternatively when the organic compound layer has a buffer layer and a light-emitting layer, as well as additional one or more other layers (three or more functionally separated layers), each of the other layers excluding the buffer and light-emitting layers means a carrier transport layer, i.e., a hole-transporting layer, an electron-transporting layer, or a hole- and electron-transporting layer, and at least one of the layers contains the charge-transporting polyether.

Specifically, the organic compound layer may have, for example, a configuration including at least a buffer layer, a light-emitting layer and an electron-transporting layer, a configuration including at least a buffer layer, a hole-transporting layer, a light-emitting layer and an electron-transporting layer, or a configuration including at least a buffer layer, a hole-transporting layer and a light-emitting layer. In such a case, at least one layer thereof (hole-transporting layer, electron-transporting layer, or light-emitting layer) preferably contains the charge-transporting polyether, however preferably, the charge-transporting polyether is the hole-transporting material. In particular, it is preferable that at least the light-emitting layer or the hole-transporting layer which is in contact with the buffer layer contains the charge-transporting polyether.

When the organic compound layer is made only of a buffer layer and a light-emitting layer, the buffer layer is provided between the anode and the light-emitting layer. Alternatively when it contains at least a buffer layer, a light-emitting layer and an electron-transporting layer, the buffer layer is provided between the anode and the light-emitting layer. Alternatively when it contains at least a buffer layer, a hole-transporting layer, a light-emitting layer and an electron-transporting layer, the buffer layer is provided between the anode and the hole-transporting layer. Yet alternatively when it contains at least a buffer layer, a hole-transporting layer and a light-emitting layer, the buffer layer is provided between the anode and the hole-transporting layer.

The processability and the luminous efficiency are both more favorable in the configuration containing a buffer layer, a light-emitting layer and an electron-transporting layer than in other layer structures. The number of layers is smaller in the configuration than in the completely functionally separated layer structures; the mobility of electron, which is generally lower than that of hole, is elevated; and thus, the charges are seemingly balanced in the light-emitting layer.

The device in the configuration including a buffer layer, a hole-transporting layer, a light-emitting layer and an electron-transporting layer is superior in luminous efficiency to the devices in other layer structures, and allows low-voltage drive. Seemingly it is because the charge injection efficiency is highest in the layer structure of entire functional separation than other layer structures, and the charges are recombined in the light-emitting layer.

Both the processability and the durability are more favorable in the configuration including a buffer layer, a hole-transporting layer and a light-emitting layer than in other configurations. Seemingly it is because the number of layers is smaller in the configuration than in entirely functionally separated layer structures, the hole injection efficiency into the light-emitting layer is improved, and injection of excessive electron in the light-emitting layer is prevented.

Increase in the area and production of the device are easier in the configuration including only a buffer layer and a light-emitting layer than in other layer structures. It is because the number of layers is smaller and the device can be produced, for example, by wet coating.

In the organic electroluminescent device in the exemplary embodiment, the light-emitting layer may contain a charge-transporting material (hole- or electron-transporting material other than the charge-transporting polyether), and the charge-transporting material will be described below in detail.

Hereinafter, the organic electroluminescent device in the exemplary embodiment will be described in more detail with reference to drawings, however the invention is not limited by these exemplary embodiments.

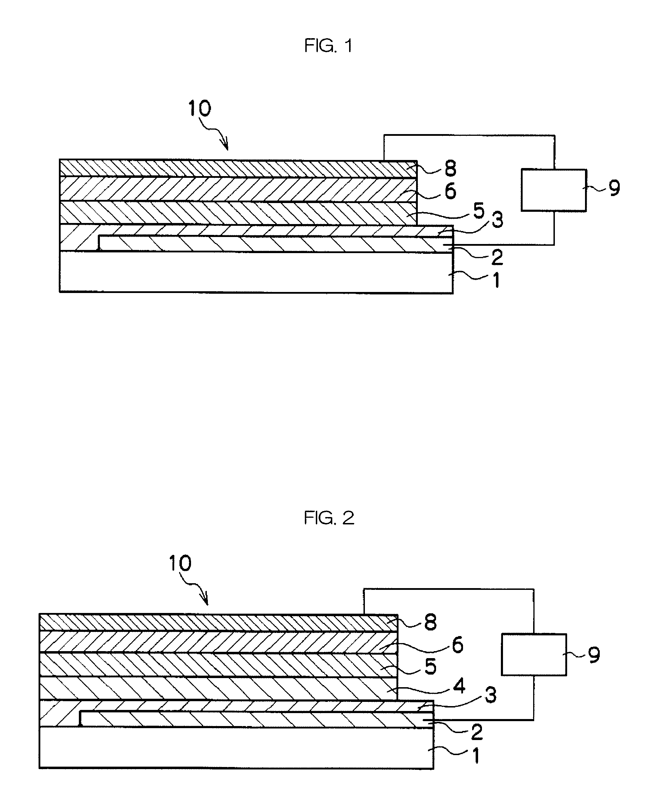

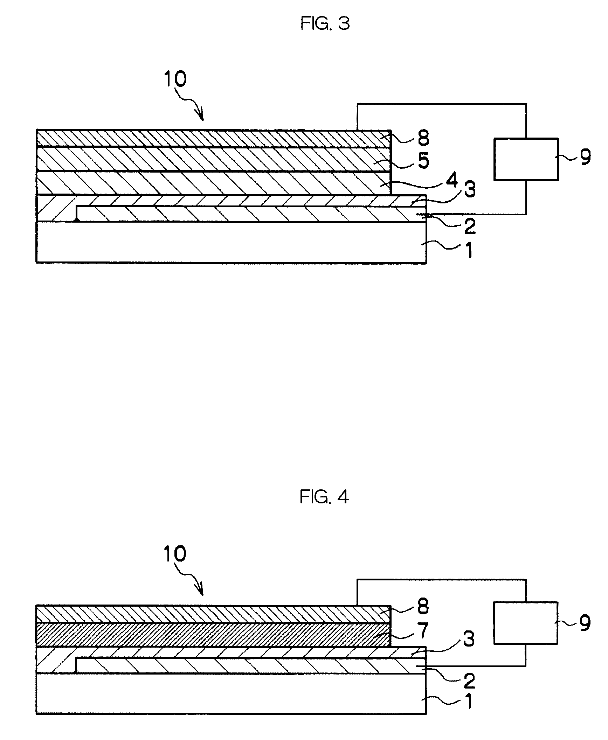

Figures 1 to 4 are schematic sectional views illustrating the layer structure of the organic electroluminescent devices according to aspects of the invention, and Figures 1, 2, and 3 respectively show examples of the devices having three or four organic compound layers, while Figure 4 shows an example of the device having two organic compound layers. The invention will be described hereinafter, as the same codes are allocated to the units having the same function in Figures 1 to 4.

The organic electroluminescent device 10 shown in Figure 1 has a transparent insulator substrate 1, and a transparent electrode 2, a buffer layer 3, a light-emitting layer 5, an electron-transporting layer 6 and a rear-face electrode 8 formed thereon successively.
The organic electroluminescent device 10 shown in Figure 2 has a transparent insulator substrate 1, and a transparent electrode 2, a buffer layer 3, a hole-transporting layer 4, a light-emitting layer 5, an electron-transporting layer 6 and a rear-face electrode 8 formed thereon successively.
The organic electroluminescent device 10 shown in Figure 3 has a transparent insulator substrate 1, and a transparent electrode 2, a buffer layer 3, a hole-transporting layer 4, a light-emitting layer 5 and a rear-face electrode 8 formed thereon in this order.
The organic electroluminescent device 10 shown in Figure 4 has a transparent insulator substrate 1, and a transparent electrode 2, a buffer layer 3, a charge-transporting light-emitting layer 7, and a rear-face electrode 8 formed thereon in this order.

In Figures 1 to 4, the transparent electrode 2 is an anode, and the rear-face electrode 8 is a cathode. Hereinafter, each component will be described in detail.

The layer having the charge-transporting polyether may function as a light-emitting layer 5 or an electron-transporting layer 6, depending on its structure, in the layer structure of the organic electroluminescent device 10 shown in Figure 1; as a hole-transporting layer 4 or an electron-transporting layer 6, in the layer structure of the organic electroluminescent device 10 shown in Figure 2; as a hole-transporting layer 4 or a light-emitting layer 5, in the layer structure of the organic electroluminescent device 10 shown in Figure 3; and as a light-emitting layer 7 having a charge-transporting property in the layer structure of the organic electroluminescent device 10 shown in Figure 4. In particular, the charge-transporting polyether functions preferably as a hole-transporting material.

The transparent insulator substrate 1 is preferably transparent for light transmission, and examples thereof include, but are not limited to, glass, plastic film, and the like. The transparent electrode 2 is also preferably transparent for light transmission, similarly to the transparent insulator substrate, and has a large work function (ionization potential) for hole injection, and examples thereof include, but are not limited to, oxide layers such as of indium tin oxide (ITO), tin oxide (NESA), indium oxide, and zinc oxide, and metal films, such as of gold, platinum, and palladium, formed by vapor deposition or sputtering.

The buffer layer 3, which is formed in contact with the anode (transparent electrode 2), contains one or more charge injection materials. The charge injection material having the substituted silicon group is used as the charge injection material. Specifically, for example, the buffer layer 3 contains a three-dimensionally crosslinked product formed with the charge injection material having the substituted silicon group.

The charge injection material preferably has an ionization potential of 5.4 eV or less, more preferably 5.1 eV or less, for improvement in the efficiency of injecting electron into the layer provided in contact with the face opposite to the anode of the buffer layer 3 (i.e., light-emitting layer 5 in Figure 1, hole-transporting layer 4 in Figures 2 and 3, and charge-transporting light-emitting layer 7 in Figure 4). The number of the buffer layers 3 is also not particularly limited, but preferably 1 or 2, particularly preferably 1.

Examples of the materials for constituting the buffer layer 3 include the materials described above, and other non-charge injection materials such as binder resins may be used as needed.

The electron-transporting layer 6 may be formed only with the charge-transporting polyether with an added function (electron-transporting property) according to applications, but may be formed together with an electron-transporting material other than the charge-transporting polyether in an amount in the range of 1 to 50 wt%, for example for further improvement in electrical characteristics for control of electron transfer efficiency.

Favorable examples of the electron-transporting materials include oxadiazole compounds, triazole compounds, phenylquinoxaline compounds, nitro-substituted fluorenone compounds, diphenoquinone compounds, thiopyranedioxide compounds, fluorenylidenemethane compounds and the like. Specifically favorable examples thereof include, but are not limited to, the following compounds (VII-1) to (VII-3): When the electron-transporting layer 6 is formed without use of the charge-transporting polyether, the electron-transporting layer 6 is formed with the electron-transporting material.

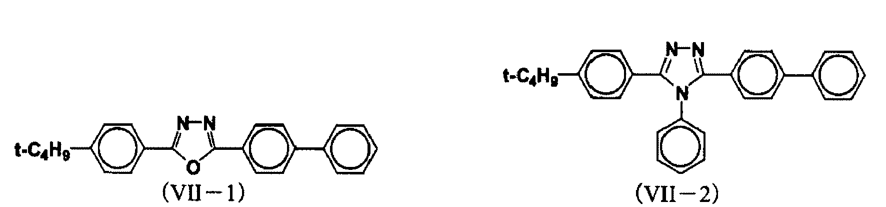

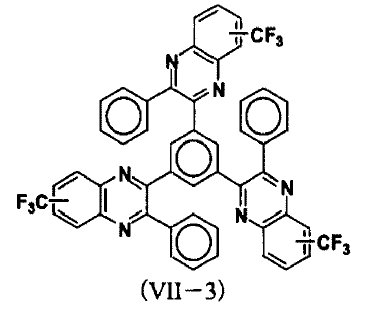

The hole-transporting layer 4 may be formed only with a charge-transporting polyether with an added functional (hole-transporting property) according to applications, but may be formed together with a hole-transporting material other than the charge-transporting polyether in an amount in the range of equal to or approximately1 to equal to or approximately 50 wt%, for control of the hole mobility.

Favorable examples of the hole-transporting materials include tetraphenylenediamine compounds, triphenylamine compounds, carbazole compounds, stilbene compounds, arylhydrazone compounds, porphyrin compounds, and the like, and particularly favorable specific examples thereof include the following compounds (VIII-1) to (VIII-7), and tetraphenylenediamine compound are particularly preferable, because they are superior in compatibility with the charge-transporting polyether. The material may be used as mixed, for example, with another common resin. When the hole-transporting layer 4 is formed without using the charge-transporting polyether, the hole-transporting layer 4 is formed with the hole-transporting material. In the compound (VII-7), n (integer) is preferably in the range of equal to or approximately 10 to equal to or approximately 100,000, more preferably in the range of equal to or approximately 1,000 to equal to or approximately 50,000.

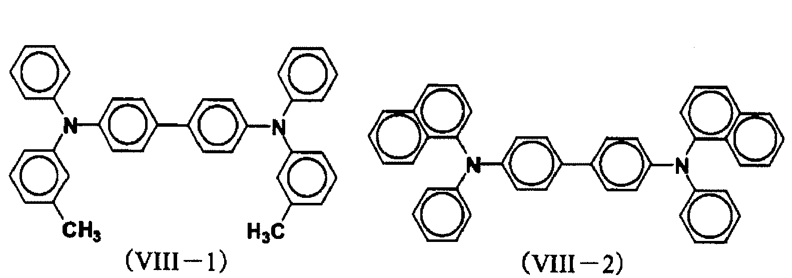

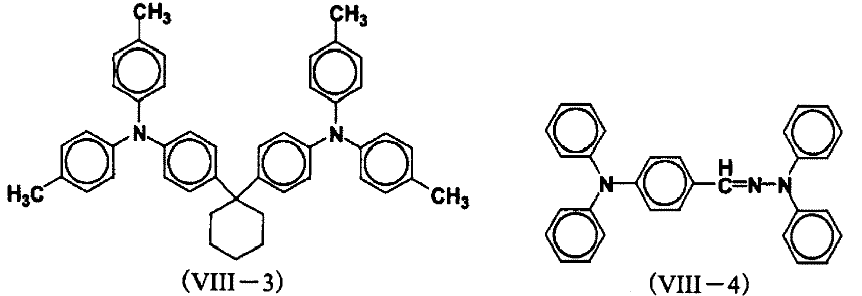

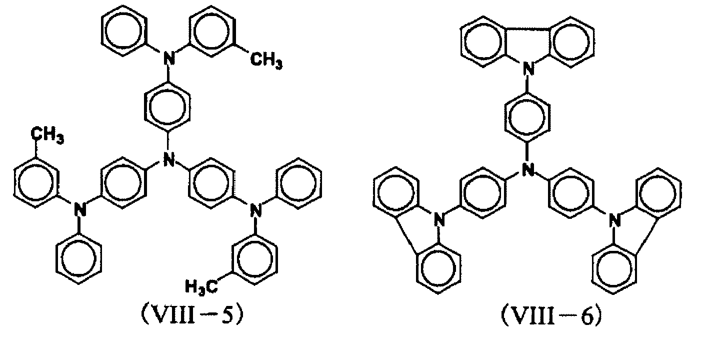

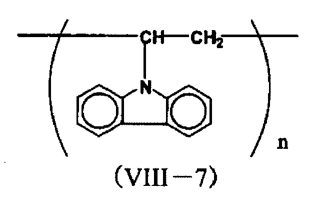

A compound having a fluorescence quantum yield higher than that of other compounds in the solid state is used as the light-emitting material in the light-emitting layer 5. When the light-emitting material is an organic low-molecular weight, the compound should give a favorable thin film by vacuum deposition or by coating/drying of a solution or dispersion containing a low-molecular weight compound and a binder resin. Alternatively when it is a polymer, it should give a favorable thin film by coating/drying of a solution or dispersion containing it.

If it is an organic low-molecular weight compound, favorable examples thereof include chelating organic metal complexes, polynuclear or fused aromatic ring compounds, perylene compounds, coumarin compounds, styryl arylene compounds, silole compounds, oxazole compounds, oxathiazole compounds, oxadiazole compounds, and the like, and when it is a polymer, examples thereof include poly-para-phenylene compounds, poly-para-phenylene vinylene compounds, polythiophene compounds, polyacetylene compounds, polyfluorene compounds and the like. Specifically preferable examples include, but are not limited to, the following compounds (IX-1) to (IX-17).

In the following formulae (IX-13) to (IX-17), each of Ar and X is a monovalent or divalent group having a structure similar to Ar and X shown in Formulae (II-1) and (II-2); each of n and x is an integer of 1 or more; and y is 0 or 1.

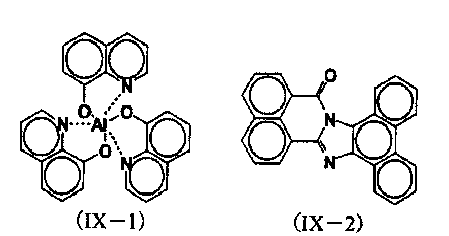

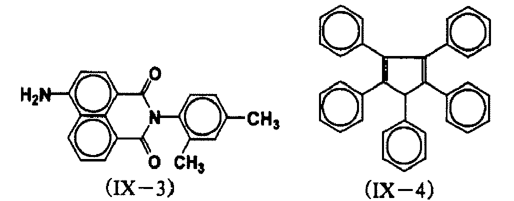

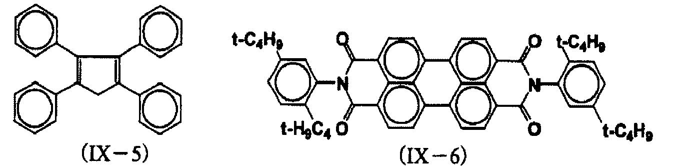

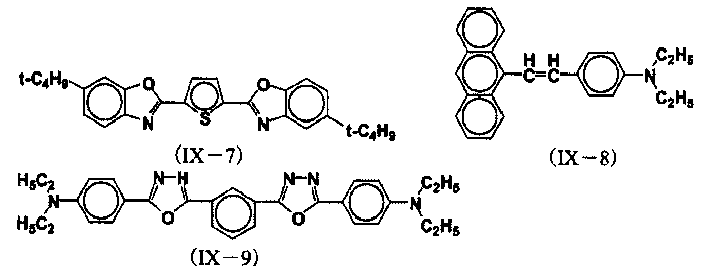

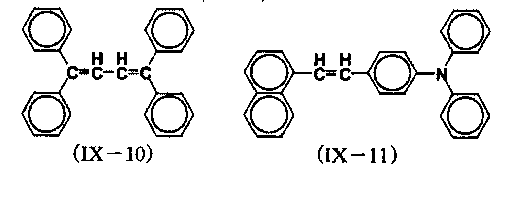

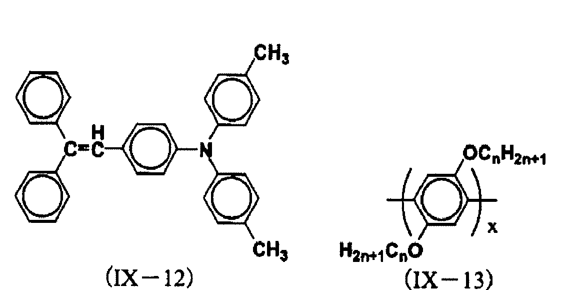

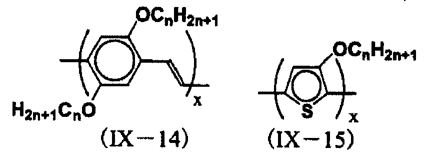

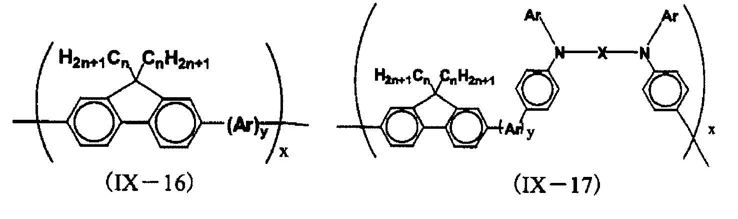

A dye compound different from the light-emitting material may be doped as a guest material into the light-emitting material, for improvement in durability or luminous efficiency of the organic electroluminescent device 10. Doping is performed by vapor co-deposition when the light-emitting layer is formed by vacuum deposition, while by mixing to a solution or dispersion when the light-emitting layer is formed by coating/drying of the solution or dispersion. The degree of the dye compound doping in the light-emitting layer is approximately 0.001 to 40 wt%, preferably approximately 0.01 to 10 wt%.

The dye compound used in doping is preferably an organic compound preferably compatible with the light-emitting material, giving a favorable thin-film light-emitting layer, and favorable examples thereof include DCM compounds, quinacridone compounds, rubrene compounds, porphyrin compounds and the like. Specifically favorable examples thereof include, but are not limited to, the following compounds (X-1) to (X-4).

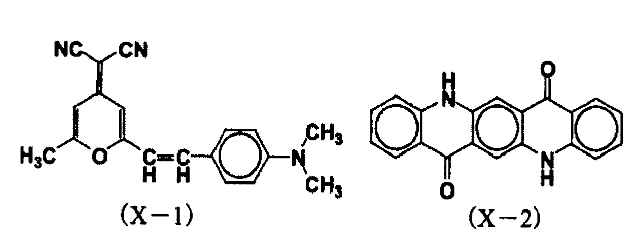

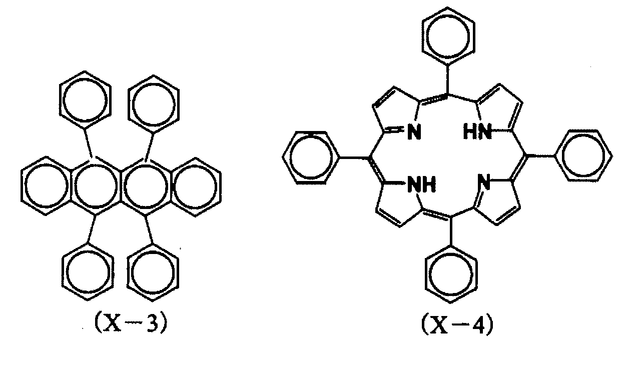

The light-emitting layer 5 may be formed only with the light-emitting material; a charge-transporting polyether described above may be added to and dispersed in the light-emitting material in an amount in the range of about 1 to about 50 wt%, for example for further improvement in electrical properties and light-emitting characteristics; or a charge-transporting material other than the charge-transporting polyether may be added to and dispersed in the light-emitting polymer in an amount in the range of about 1 to about 50 wt% before preparation of the light-emitting layer.

When the charge-transporting polymer has light-emitting characteristics, it may be used as an emitting material, and in such a case, for example for further improvement in electrical properties and light-emitting characteristics, a charge-transporting material other than the charge-transporting polyether may be added to and dispersed in the light-emitting material in an amount in the range of about 1 to about 50 wt%.

The light-emitting layer 7 having a charge-transporting property preferably has a material having any one of the light-emitting materials (IX-1) to (IX-17) as its light-emitting material in an amount of about 50 wt% or less relative to the total amount of the light-emitting layer 7, as it is dispersed in the charge-transporting polyether and is imparted with a function (hole- or electron-transporting property) in accordance with purposes. In such a case, a charge-transporting material other than the charge-transporting polyether may be dispersed in the organic electroluminescent device 10 in an amount of about 10 to about 50 wt% relative to the total amount of the light-emitting layer 7 for control of the balance of hole and electron injected.

The charge-transporting material for adjustment of electron transfer efficiency, i.e., electron-transporting material, is preferably an oxadiazole compound, a nitro-substituted fluorenone compound, a diphenoquinone compound, a thiopyranedioxide compound, a fluorenylidenemethane compound or the like. Specifically favorable examples include the exemplary compounds (VII-1) to (VII-3). The charge-transporting material for use is preferably an organic compound having no strong electronic interaction with the charge-transporting polyether, and preferable examples thereof include the following compound (XI).

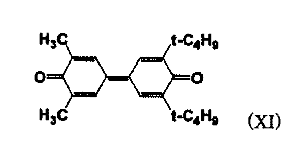

Similarly for adjustment of hole mobility, the hole-transporting material is preferably a tetraphenylenediamine compound, a triphenylamine compound, a carbazole compound, a stilbene compound, an aryl hydrazone compound, a porphyrin compound, or the like, and specifically favorable examples thereof include the exemplary compounds (VIII-1) to (VIII-7). Among these, tetraphenylenediamine compounds are preferable, because they are more compatible with the charge-transporting polyether.

A metal element allowing vacuum deposition and having a small work function permitting electron injection is used for the rear-face electrode 8, and particularly favorable examples thereof include magnesium, aluminum, silver, indium, the alloys thereof, metal halogen compounds such as lithium fluoride and lithium oxide, and metal oxides.

A protective layer may be provided additionally on the rear-face electrode 8 for prevention of degradation of the device by water or oxygen. Specific examples of a material for the protective layer include metals such as In, Sn, Pb, Au, Cu, Ag, or Al; metal oxides such as MgO, SiO₂, and TiO₂; and resins such as polyethylene resin, polyurea resin, or polyimide resin. Vacuum deposition, sputtering, plasma polymerization, CVD, or coating may be used in forming the protective layer.

The organic electroluminescent device 10 shown in any one of Figures 1 to 4 can be prepared in the following manner: First, a buffer layer 3 is formed on a transparent electrode 2 previously formed on a transparent insulator substrate 1 by coating a coating solution obtained by dissolving the components in solvent on the transparent electrode 2 by spin coating or dip coating and hardening the resulting film as needed, for example, by heating.

The buffer layer 3 may further include as necessary in addition to the charge injection material, for example, a binder resin and a coatability improving agent to such an extent that it does not become a hole trap. In addition, other silane coupling agents, aluminum coupling agents, titanate coupling agents, or the like may be added for other purposes.

Then, a hole-transporting layer 4, a light-emitting layer 5, an electron-transporting layer 6, and a light-emitting layer 7 having a charge-transporting property are formed on the buffer layer 3 according to the layer structure of each organic electroluminescent device 10. Each layer is laminated additionally in a particular order on these layers according to the layer structure of each organic electroluminescent device.

As described above, the light-emitting layer having a hole-transporting layer 4, a light-emitting layer 5, an electron-transporting layer 6 and a charge-transporting property 7 can be formed by vacuum deposition of the material for each layer. Alternatively, the layer is formed for example by spin coating or dip coating, by using a coating solution obtained by dissolving materials for each layer in organic solvent.

When a polymer is used as the charge-transporting material or the light-emitting material, each layer is preferably formed by a casting method of using a coating solution, while the each layer may be formed by an inkjet method.

The film thickness of the formed buffer layer is preferably in the range of from equal to or approximately 1 nm to equal to or approximately 100 nm, particularly in the range of from equal to or approximately 10 nm to equal to or approximately 15 nm.

The thickness of the hole-transporting layer 4, the light-emitting layer 5 or the electron-transporting layer 6 is preferably in the range of from equal to or approximately 20 nm to equal to or approximately 100 nm, particularly in the range of equal to or approximately 30 to equal to or approximately 80 nm. The thickness of the light-emitting layer 7 having a charge-transporting property is preferably equal to or approximately 20 nm to equal to or approximately 200 nm, and is more preferably equal to or approximately 30 to equal to or approximately 200 nm.
In a case where the organic compound layer (the hole-transporting layer 4, the light-emitting layer 5 or the light-emitting layer 7 having a charge-transporting property) which is adjacent to the buffer layer 3 includes the charge-transporting polyether, the thickness of the organic compound layer is preferably equal to or approximately 20 nm to equal to or approximately 100 nm, and is more preferably equal to or approximately 30 to equal to or approximately 60 nm.

Each material (the charge-transporting polyether, light-emitting material, etc.) may be present in the state of molecular dispersion or particular dispersion.
In the case where a film-forming method using a coating solution is utilized, it is necessary to use a solvent which is capable of dissolving respective materials to obtain a coating solution in the molecular dispersion state, and the dispersion solvent should be properly selected considering the dispersibility and solubility of respective materials in order to obtain a coating solution in the state having particulates being dispersed. Various means such as ball mill, sand mill, paint shaker, attriter, homogenizer, and ultrasonicator are usable in preparing particular dispersion.

Finally, a rear-face electrode 8 is formed on the light-emitting layer 5, the electron-transporting layer 6 or the light-emitting layer 7 having a carrier-transporting property by vacuum deposition or the like to give an organic electroluminescent device 10 shown in any one of Figure 1 to 4.

Display device
The display device of the exemplary embodiment has the organic electroluminescent device of the exemplary embodiment and a driving means for driving the organic electroluminescent device.
Examples of the display device include those, as specifically shown in Figures 1 to 4, having, as the driving means, a voltage-applying device 9 which is connected to the pair of the transparent electrode 2 and the rear-face electrode 8 of the organic electroluminescent device 10 and applies a DC voltage between the pair of electrodes.
Examples of the method for driving the organic electroluminescent device 10 by using the voltage-applying device 9 include a method including applying, between the pair of electrodes, a DC voltage of about 4 to about 20 V at a current density of about 1 to about 200 mA/cm² so that the organic electroluminescent device 10 emits light.

While a minimum unit (one pixel unit) of each of the exemplary embodiments has been referred for explaining the organic electroluminescent device of the present invention, the organic electroluminescent device is off course applicable to any display devices having plural pixel units (organic electroluminescent devices) arranged in a matrix form. The electrode pairs may be formed in a matrix form.

Any conventionally known technology, such as a simple matrix driving method of using multiple line electrodes and row electrodes and driving the row electrodes collectively according to the image information for each line electrode while the line electrodes, or active matrix driving method of using pixel electrodes allocated to respective pixels are scanned, may be used as the method of driving the display device.

### EXAMPLES

Hereinafter, the present invention will be described specifically with reference to Examples. However, the invention is not restricted by these Examples.

### Synthesis of charge transporting polyether

### Synthesis example 1

2.0 g of the compound (XIII-1) is placed in a 50-ml three-necked, pear-shaped flask, and allowed to react under heating at 210°C for 8 hours under reduced pressure of 4.8 Pa. Thereafter, the flask is cooled to room temperature, and the reactant is dissolved in 50 ml of monochlorobenzene under heating. Insolubles are filtered through a 0.5-µm PTFE filter, and the filtrate is added dropwise to 500 ml of methanol under stirring thereby precipitating a polymer. The polymer is filtered, thoroughly washed with methanol, and then dried to obtain 1.8 g of charge transporting polyether (XIII-2). The molecular weight distribution is measured by GPC (gel permeation chromatography), and is found to have a molecular weight of 7.85 x 10⁴ (polystyrene standard), wherein Mw/Mn is 1.82.

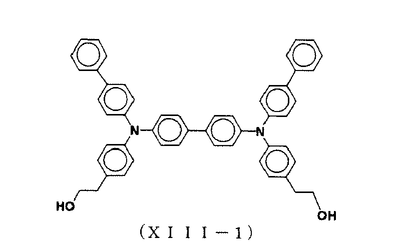

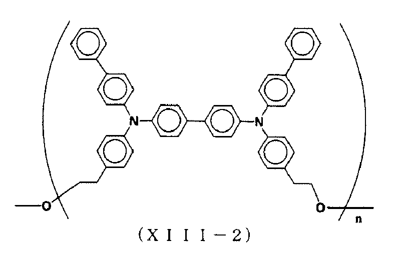

### Synthesis example 2

2.0 g of the compound (XIV-1) is placed in a 50-ml three-necked, pear-shaped flask, and allowed to react under heating at 210°C for 8 hours under reduced pressure of 4.8 Pa. Thereafter, the flask is cooled to room temperature, and the reactant is dissolved in 50 ml of monochlorobenzene under heating. Insolubles are filtered through a 0.5-µm PTFE filter, and the filtrate is added dropwise to 500 ml of methanol under stirring thereby precipitating a polymer. The polymer is filtered, thoroughly washed with methanol, and then dried to obtain 1.8 g of charge transporting polyether (XIV-2). The molecular weight distribution is measured by GPC (gel permeation chromatography), and is found to have a molecular weight of 9.24 x 10⁴ (polystyrene standard), wherein Mw/Mn is 1.90.

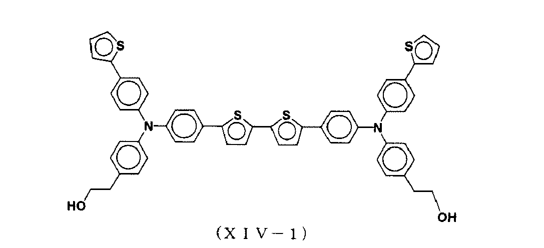

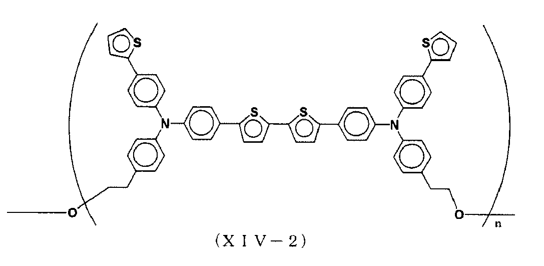

### Synthesis example 3

2.0 g of the compound (XVII-1) is placed in a 50-ml three-necked, pear-shaped flask, and allowed to react under heating at 210°C for 8 hours under reduced pressure of 4.8 Pa. Thereafter, the flask is cooled to room temperature, and the reactant is dissolved in 50 ml of monochlorobenzene under heating. Insolubles are filtered through a 0.5-µm PTFE filter, and the filtrate is added dropwise to 500 ml of methanol under stirring thereby precipitating a polymer. The polymer is filtered, thoroughly washed with methanol, and then dried to obtain 1.8 g of charge transporting polyether (XVII-2). The molecular weight distribution is measured by GPC (gel permeation chromatography), and is found to have a molecular weight of 1.04 x 10⁵ (polystyrene standard), wherein Mw/Mn is 2. 04.

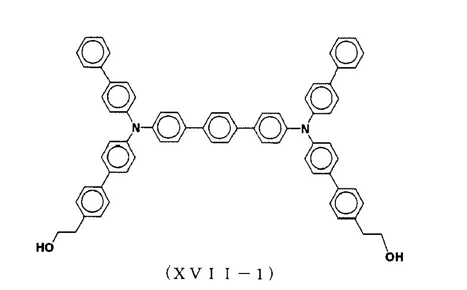

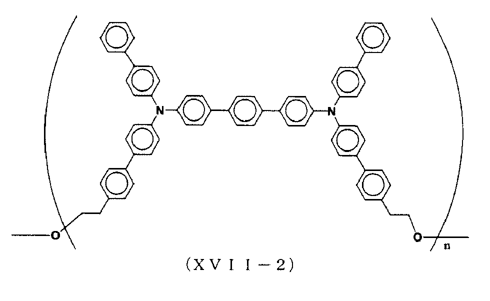

### Synthesis example 4

2.0 g of the compound (XV-1) is placed in a 50-ml three-necked, pear-shaped flask, and allowed to react under heating at 210°C for 8 hours under reduced pressure of 4.8 Pa. Thereafter, the flask is cooled to room temperature, and the reactant is dissolved in 50 ml of monochlorobenzene under heating. Insolubles are filtered through a 0.5-µm PTFE filter, and the filtrate is added dropwise to 500 ml of methanol under stirring thereby precipitating a polymer. The polymer is filtered, thoroughly washed with methanol, and then dried to obtain 1.9 g of charge transporting polyether (XV-2). The molecular weight distribution is measured by GPC (gel permeation chromatography), and is found to have a molecular weight of 8.65 x 10⁴ (polystyrene standard), wherein Mw/Mn is 1.88.

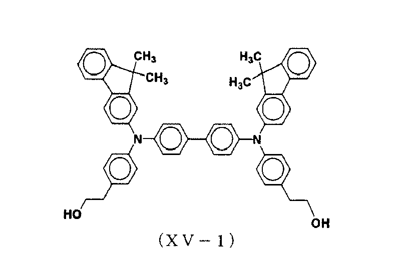

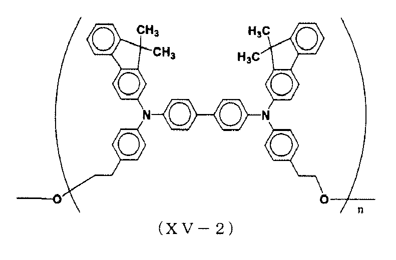

### Synthesis example 5

2.0 g of the compound (XVI-1) is placed in a 50-ml three-necked, pear-shaped flask, and allowed to react under heating at 210°C for 8 hours under reduced pressure of 4.8 Pa. Thereafter, the flask is cooled to room temperature, and the reactant is dissolved in 50 ml of monochlorobenzene under heating. Insolubles are filtered through a 0.5-µm PTFE filter, and the filtrate is added dropwise to 500 ml of methanol under stirring thereby precipitating a polymer. The polymer is filtered, thoroughly washed with methanol, and then dried to obtain 1.9 g of charge transporting polyether (XVI-2). The molecular weight distribution is measured by GPC (gel permeation chromatography), and is found to have a molecular weight of 8.15 x 10⁴ (polystyrene standard), wherein Mw/Mn is 1.78.

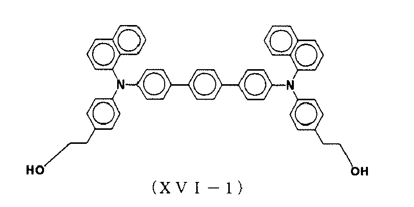

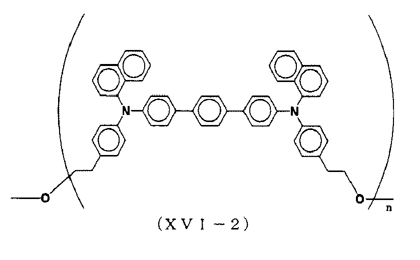

Preparation of Organic electroluminescent device
Then, an organic electroluminescent device is prepared in the following manner by using the charge-transporting polyether prepared as described above.

### Example 1

A solution containing 500 mg of a charge injection material having substituted silicon groups [following formula (XIX), ionization potential: 5.0 eV] and 2 mg of hydrochloric acid (1N) dissolved in 1 ml of butanol 1 ml is prepared as the buffer layer-forming solution.

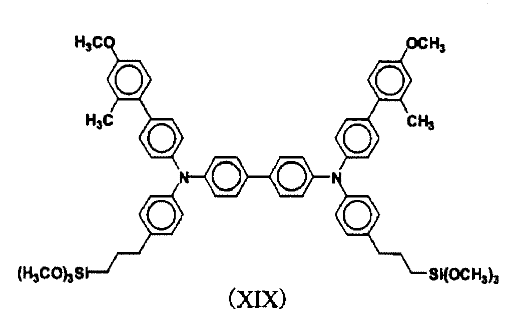

Separately, a substrate having a strip ITO electrode of 2 mm in width (hereinafter, referred to as "ITO electrode-carrying glass plate") is prepared as the transparent electrode-carrying substrate.

Then, the solution above is applied on the ITO electrode-sided surface of the ITO electrode-carrying glass plate dried after cleaning by spin coating and hardened and dried sufficiently by heating at 120°C for 1 hour, to give a buffer layer having a film thickness of 10 nm.
Then, a chlorobenzene solution containing 5 wt% of an emitting polymer [following compound (XX), polyfluorene polymer, Mw: 1×10⁵] as the light-emitting material and 1 wt% of a charge-transporting polyether [compound (XIII-2) (Mw: 6.98×10⁴)] as the hole-transporting material, for example for further improvement in electrical properties and light-emitting characteristics, is filtered through a polytetrafluoroethylene (PTFE) filter having an opening of 0.1 µm, and a light-emitting layer having a film thickness of 30 nm is formed on the buffer layer by spin coating by using the solution thus obtained.

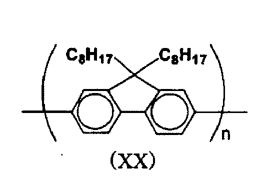

After the light-emitting layer formed is dried sufficiently, a dichloroethane solution containing a charge-transporting polyether [compound (XIV-2) (Mw: 9.45 x 10⁴)] at 5 wt% as the electron-transporting material is filtered through a PTFE filter having an opening of 0.1 µm, and an electron-transporting layer having a film thickness of 30 nm is formed by coating the solution on the light-emitting layer by spin coating.
Finally, a Mg-Ag alloy is deposited thereon by vapor co-deposition, forming a rear-face electrode of 2 mm in width and 150 nm in thickness that crosses the ITO electrode. The effective area of the formed organic EL device is 0.04 cm².

### Example 2

A buffer layer is formed on an ITO electrode-carrying glass plate cleaned similarly to Example 1 by using the charge injection material containing substituted silicon groups represented by Structural Formula (XIX) above [ionization potential: 5.0 eV]; a chlorobenzene solution having the charge-transporting polyether [compound (XIII-2) (Mw: 6.98×10⁴)] at 5 wt% as the hole-transporting material is filtered though a polytetrafluoroethylene (PTFE) filter having an opening of 0.1 µm, and the solution obtained is coated on the buffer layer by spin coating, to form a hole-transporting layer having a film thickness of 30 nm.
After sufficient drying, a chlorobenzene solution containing an emitting polymer [compound (XX), polyfluorene polymer, Mw: ca. 1×10⁵] at 5 wt% as the light-emitting material is filtered through a PTFE filter having an opening of 0.1 µm, and the solution obtained is applied on the hole-transporting layer by spin coating, to form a light-emitting layer having a thickness of 50 nm.

A dichloroethane solution containing a charge-transporting polyether [compound (XIV-2) (Mw: 9.45 10⁴)] at 5 wt% as the electron-transporting material is filtered through a PTFE filter having an opening of 0.1 µm, and the solution obtained is applied on the light-emitting layer by spin coating, to form a electron-transporting layer having a film thickness of 30 nm.
Finally, a Mg-Ag alloy is deposited thereon by vapor co-deposition, forming a rear-face electrode of 2 mm in width and 150 nm in thickness that crosses the ITO electrode. The effective area of the formed organic EL device is 0.04 cm².

### Example 3

A buffer layer is formed on an ITO electrode-carrying glass plate cleaned similarly to Example 1 by using the charge injection material substituted containing silicon groups represented by Structural Formula (XIX) above [ionization potential: 5.0 eV]; a chlorobenzene solution having the charge-transporting polyether [compound (XIII-2) (Mw: 6.98×10⁴)] at 5 wt% as the hole-transporting material is filtered though a polytetrafluoroethylene (PTFE) filter having an opening of 0.1 µm, and the solution obtained is coated on the buffer layer by spin coating, to form a hole-transporting layer having a film thickness of 30 nm.
After sufficient drying, a chlorobenzene solution containing an emitting polymer [compound (XX), polyfluorene polymer, Mw: ca. 1 X 10⁵] at 5 wt% as the light-emitting material is filtered through a PTFE filter having an opening of 0.1 µm, and the solution obtained is applied on the hole-transporting layer by spin coating, to form a light- emitting layer having a thickness of 50 nm.
Finally, a Mg-Ag alloy is deposited thereon by vapor co-deposition, forming a rear-face electrode of 2 mm in width and 150 nm in thickness that crosses the ITO electrode. The effective area of the formed organic EL device is 0.04 cm².

### Example 4

A buffer layer is formed on an ITO electrode-carrying glass plate cleaned similarly to Example 1 by using the charge injection material containing substituted silicon groups represented by Structural Formula (XIX) above [ionization potential: 5.0 eV]; 0.5 part by weight of a charge-transporting polyether [compound (XIII-2) (Mw: 6.98×10⁴)] as the hole-transporting material and 0.1 part by weight of an emitting polymer [compound (XX), polyfluorene polymer, Mw: ca. 1×10⁵] as the light-emitting material are mixed to each other, and a chlorobenzene solution containing the mixture thereof at 10 wt% is filtered through a polytetrafluoroethylene (PTFE) filter having an opening of 0.1 µm, to give a solution for forming light-emitting layer.

The solution is coated on the buffer layer by spin coating, to form charge-transporting light-emitting layer having a film thickness of 50 nm, and finally, a Mg-Ag alloy is deposited thereon by vapor co-deposition, forming a rear-face electrode of 2 mm in width and 150 nm in thickness that crosses the ITO electrode. The effective area of the formed organic EL device is 0.04 cm².

### Example 5

An organic EL device is prepared in a similar manner to Example 1, except that the material represented by the following formula (XXI) [ionization potential: 5.4 eV] is used as the charge injection material containing substituted silicon group for forming the buffer layer, and a solution containing 500 mg of a charge-transporting material and 2 mg of hydrochloric acid (1N) in 1 ml of butanol is coated by spin coating and hardened under heat at 120°C for 1 hour, to give a buffer layer having a film thickness of 10 nm after sufficient drying.

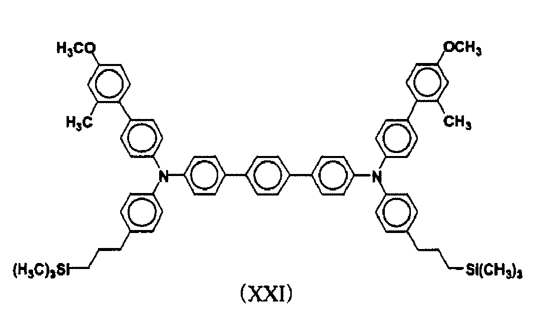

### Example 6

An organic EL device is prepared in a similar manner to Example 2, except that the material represented by the following formula (XXI) [ionization potential: 5.4 eV] is used as the charge injection material containing substituted silicon group for forming the buffer layer, and a solution containing 500 mg of a charge-transporting material and 2 mg of hydrochloric acid (1N) in 1 ml of butanol is coated by spin coating and hardened under heat at 120°C for 1 hour, to give a buffer layer having a film thickness of 10 nm after sufficient drying.

### Example 7

An organic EL device is prepared in a similar manner to Example 3, except that the material represented by the following formula (XXI) [ionization potential: 5.4 eV] is used as the charge injection material containing substituted silicon group for forming the buffer layer, and a solution containing 500 mg of a charge-transporting material and 2 mg of hydrochloric acid (1N) in 1 ml of butanol is coated by spin coating and hardened under heat at 120°C for 1 hour, to give a buffer layer having a film thickness of 10 nm after sufficient drying.

### Example 8

An organic EL device is prepared in a similar manner to Example 4, except that a material represented by Structural Formula (XXI) [ionization potential: 5.4 eV] is used as the hydrolytic group-containing charge injection material containing substituted silicon group for forming the buffer layer, and a solution containing 500 mg of a charge-transporting material and 2 mg of hydrochloric acid (1N) in 1 ml of butanol is coated by spin coating and hardened under heat at 120°C for 1 hour, to give a buffer layer having a film thickness of 10 nm after sufficient drying.

### Example 9

An organic EL device is prepared in a similar manner to Example 1, except that a chlorobenzene solution containing an emitting polymer [following compound (XXII), poly-para-phenylene vinylene (PPV) polymer, Mw: ca. 1×10⁵] at 5 wt% as the light-emitting material is filtered through a polytetrafluoroethylene (PTFE) filter having an opening of 0.1 µm, and the solution obtained is applied on the buffer layer by spin coating, to form a light-emitting layer having a film thickness of 30 nm.

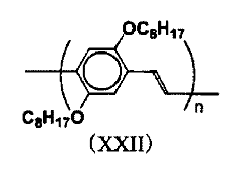

### Example 10

An organic EL device is prepared in a similar manner to Example 2, except that a chlorobenzene solution containing a light-emitting polymer [compound (XXII), PPV polymer, Mw: ca. 1 × 10⁵] at 5 wt% as the light-emitting material is filtered through a polytetrafluoroethylene (PTFE) filter having an opening of 0.1 µm and the solution obtained is coated on the hole-transporting layer by spin coating, to form a light-emitting layer having a film thickness of 30 nm.

### Example 11

An organic EL device is prepared in a similar manner to Example 3, except that a chlorobenzene solution containing a light-emitting polymer [compound (XXII), PPV polymer, Mw: ca. 1×10⁵] at 5 wt% as the light-emitting material is filtered through a polytetrafluoroethylene (PTFE) filter having an opening of 0.1 µm and the solution obtained is applied on the hole-transporting layer by spin coating, to form a light-emitting layer having a film thickness of 30 nm.

### Example 12

0.5 part by weight of a charge-transporting polyether [compound (XIV-2) (Mw: 9.45×10⁴)] as the hole-transporting material and 0.4 part by weight of a light-emitting polymer (XXII), PPV polymer, Mw: ca. 1×10⁵] as the light-emitting material are mixed to each other, and a chlorobenzene solution containing the mixture at 10 wt% is filtered through a polytetrafluoroethylene (PTFE) filter having an opening of 0.1 µm, to give a solution for forming a light-emitting layer.

An organic EL device of Example 12 is prepared in a similar manner to Example 4, except that the thus obtained solution is applied on the buffer layer by spin coating, to form a charge-transporting light-emitting layer having film thickness of 50 nm.

### Example 13

An organic EL device is prepared in a similar manner to Example 11, except that a material represented by the Structural Formula (XXI) [ionization potential: 5.4 eV] is used as the charge-transporting material containing substituted silicon group for forming the buffer layer and a solution containing 500 mg of a charge-transporting material and 2 mg of hydrochloric acid (1N) in 1 ml of butanol is coated by spin coating and hardened under heat at 120°C for 1 hour, to give a buffer layer having a film thickness of 10 nm after sufficient drying.

### Example 14

An organic EL device is prepared in a similar manner to Example 11, except that a chlorobenzene solution having the charge-transporting polyether [compound (XVII-2) (Mw: 1.04×10⁵)] at 5 wt% as the hole-transporting material is filtered through a polytetrafluoroethylene (PTFE) filter having an opening of 0.1 µm and the solution obtained is applied on the buffer layer by spin coating to form a hole-transporting layer having a film thickness of 30 nm.

### Example 15

A buffer layer of the charge-transporting material containing substituted silicon groups represented by Structural Formula (XIX) [ionization potential: 5.0 eV] is formed on an ITO electrode-carrying glass plate cleaned similarly to Example 1; a chlorobenzene solution having the charge-transporting polyether [compound (XIII-2) (Mw: 6.98 x 10⁴)] at 5 wt% as the hole-transporting material is filtered through a polytetrafluoroethylene (PTFE) filter having an opening of 0.1 µm; and the solution obtained is applied on the buffer layer by spin coating, to form a hole-transporting layer having a film thickness of 30 nm.
After sufficient drying, sublimation-purified Alq₃ (compound (IX-1)) is placed on a tungsten board as the light-emitting material, and a light-emitting layer having a film thickness of 50 nm is formed on the hole-transporting layer by vacuum deposition. The degree of vacuum then is 10⁻⁵ Torr, and the board temperature is 300°C.
Finally, a Mg-Ag alloy is deposited thereon by vapor co-deposition, forming a rear-face electrode of 2 mm in width and 150 nm in thickness that crosses the ITO electrode. The effective area of the formed organic EL device is 0.04 cm².

### Example 16

An organic EL device is prepared in a similar manner to Example 14, except that a material represented by the Structural Formula (XXI) above [ionization potential: 5.4 eV] is used as the charge-transporting material containing substituted silicon group for forming the buffer layer and a solution containing 500 mg of a charge-transporting material and 2 mg of hydrochloric acid (1N) in 1 ml of butanol is coated by spin coating and hardened under heat at 120°C for 1 hour, to give a buffer layer having a film thickness of 10 nm after sufficient drying.

### Example 17

An organic EL device is prepared in a similar manner to Example 11, except that a chlorobenzene solution having the charge-transporting polyether [compound (XV-2) (Mw: 8.65×10⁴)] at 5 wt% as the hole-transporting material is filtered through a polytetrafluoroethylene (PTFE) filter having an opening of 0.1 µm and the solution obtained is applied on the buffer layer by spin coating, to form a hole-transporting layer having a film thickness of 30 nm.

### Example 18

An organic EL device is prepared in a similar manner to Example 11, except that a chlorobenzene solution having the charge-transporting polyether [compound (XVI-2) (Mw: 8.15×10⁴)] at 5 wt% as the hole-transporting material is filtered through a polytetrafluoroethylene (PTFE) filter having an opening of 0.1 µm and the solution obtained is applied on the buffer layer by spin coating, to form a hole-transporting layer having a film thickness of 30 nm.

### Example 19

An organic EL device is prepared in a similar manner to Example 1, except that a material represented by following formula (XXIII) above [ionization potential: 5.1 eV] is used as the charge injection material containing substituted silicon group for forming the buffer layer and a solution containing 500 mg of a charge-transporting material and 2 mg of hydrochloric acid (1N) in 1 ml of butanol is coated by spin coating and hardened under heat at 120°C for 1 hour, to form a buffer layer having a film thickness of 10 nm after sufficient drying.

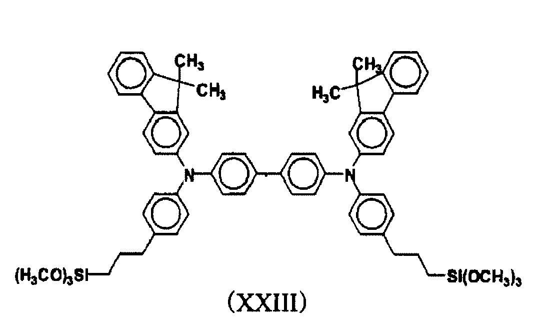

### Comparative Example 1

An organic EL device is prepared in a similar manner to Example 1, except that a light-emitting layer is formed directly on the ITO electrode-sided surface of an ITO electrode-carrying glass plate without forming a buffer layer with the charge-transporting material containing substituted silicon groups.

### Comparative Example 2

An organic EL device is prepared in a similar manner to Example 2, except that a hole-transporting layer is formed directly on the ITO electrode-sided surface of an ITO electrode-carrying glass plate without forming a buffer layer with the charge-transporting material containing substituted silicon group.

### Comparative Example 3

An organic EL device is prepared in a similar manner to Example 3, except that a hole-transporting layer is formed directly on the ITO electrode-sided surface of an ITO electrode-carrying glass plate without forming a buffer layer with the charge-transporting material containing substituted silicon group.

### Comparative Example 4

An organic EL device is prepared in a similar manner to Example 4, except that a light-emitting layer is formed directly on the ITO electrode-sided surface of an ITO electrode-carrying glass plate without forming a buffer layer with the charge-transporting material containing substituted silicon group.

### Comparative Example 5

An organic EL device is prepared in a similar manner to Example 11, except that a hole-transporting layer is formed directly on the ITO electrode-sided surface of an ITO electrode-carrying glass plate without forming a buffer layer with the charge-transporting material containing substituted silicon group.

### Comparative Example 6

An organic EL device is prepared in a similar manner to Example 3, except that Baytron P (PEDOT-PSS, manufactured by Bayer: mixed aqueous dispersion containing polyethylenedioxide thiophene [following compound (XXIV), ionization potential: 5.1 to 5.2 eV] and polystyrenesulfonic acid) is used as the charge injection material for forming the buffer layer and the solution is applied on the ITO electrode-sided surface of an ITO electrode-carrying glass plate previously dried after cleaning by spin coating and hardened under heat at 200°C for 10 minutes, to form a buffer layer having a film thickness of 10 nm after sufficient drying.

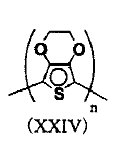

### Comparative Example 7

An organic EL device is prepared in a similar manner to Example 11, except that Baytron (Baytron)P (PEDOT-PSS, manufactured by Bayer: mixed aqueous solution containing polyethylenedioxide thiophene [the compound (XXIV), ionization potential: 5.1 to 5.2 eV] and polystyrenesulfonic acid) is used as the charge injection material for forming the buffer layer and the solution is applied on the ITO electrode-sided surface of an ITO electrode-carrying glass plate previously dried after cleaning by spin coating and hardened under heat at 200°C for 10 minutes, to form a buffer layer having a film thickness of 10 nm after sufficient drying.

### Comparative Example 8

An organic EL device is prepared in a similar manner to Example 3, except that a chlorobenzene solution containing a low-molecular-weight injection material star-burst compound [compound (VIII-5), MTDATA (4,4',4"-tris(3-methylphenylphenylamino)propyltriphenylamine), ionization potential: 5.1 eV] at 5 wt% as the charge injection material for forming the buffer layer is filtered through a PTFE filter having an opening of 0.1 µm and the solution obtained is applied on the ITO electrode-sided surface of an ITO electrode-carrying glass plate previously dried after cleaning by spin coating, to form a buffer layer having a film thickness of 10 nm after sufficient drying.

### Comparative Example 9

An organic EL device is prepared in a similar manner to Example 11, except that a chlorobenzene solution containing a low-molecular-weight injection material star-burst compound [compound (VIII-5), MTDATA, ionization potential: 5.1 eV] at 5 wt% as the charge injection material for forming the buffer layer is filtered through a PTFE filter having an opening of 0.1 µm, and the solution obtained is applied on the ITO electrode-sided surface of an ITO electrode-carrying glass plate previously dried after cleaning by spin coating, to form a buffer layer having a film thickness of 10 nm after sufficient drying.

### Comparative Example 10)

An organic EL device is prepared in a similar manner to Example 3, except that a vinyl skeleton-containing charge-transporting polymer [following compound (XXV), Mw: 5.46×10⁴ (as styrene)] is used as the hole-transporting material in place of the charge-transporting polyether [compound (XIII-2)].

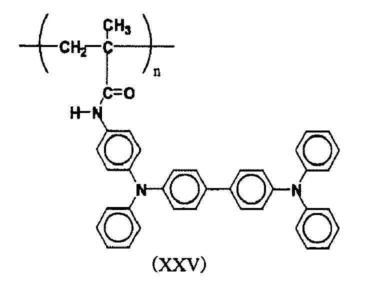

### Comparative Example 11

An organic EL device is prepared in a similar manner to Example 3, except that a polycarbonate skeleton-containing charge-transporting polymer [following compound (XXVI), Mw: 7.83×10⁴ (as styrene)] is used as the hole-transporting material in place of the charge-transporting polyether [compound (XIII-2)].

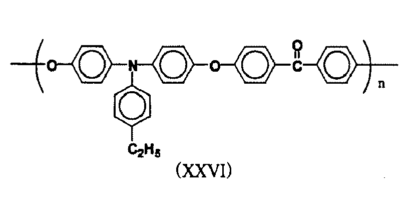

### Comparative Example 12

An organic EL device is prepared in a similar manner to Example 11, except that a vinyl skeleton-containing charge-transporting polymer [the compound (XX V), Mw: 5.46×10⁴ (as styrene)] is used as the hole-transporting material in place of the charge-transporting polyether [compound (XIII-2)].

### Comparative Example 13

An organic EL device is prepared in a similar manner to Example 11 except that a polycarbonate skeleton-containing charge-transporting polymer [compound (XXVI), Mw: 7.83×10⁴ (as styrene)] is used as the hole-transporting material in place of the charge-transporting polyether [compound (XIII-2)].

Evaluation
The start-up voltage (driving voltage), the maximum brightness, and the drive current density at the maximum brightness when DC voltage is applied between the ITO electrode (plus), and the Mg-Ag rear-face electrode (minus) of each of the organic EL devices thus prepared under vacuum (133.3×10⁻³ Pa (10⁻⁵ Torr)) for light emission are evaluated. The results are summarized in Table 3.
Separately, the device lifetime (emission lifetime) of each organic EL device is determined under dry nitrogen. The device lifetime is determined at a current giving an initial brightness of 50cd/m², and the device lifetime (hour) is the period until the brightness decreases to half of the initial value under constant-current drive. The device lifetime then is also shown in Table 3.

**Table 3**

| | Start-up voltage (V) | Maximum brightness (cd/m²) | Drive current ² density (mA/cm²) | Device lifetime (hour) |
|---|---|---|---|---|
| Example 1 | 2.3 | 8,300 | 285 | 48 |
| Example 2 | 2.1 | 11,700 | 355 | 61 |
| Example 3 | 2.4 | 10,500 | 320 | 60 |
| Example 4 | 3.2 | 5,600 | 240 | 43 |
| Example 5 | 3.7 | 7,500 | 280 | 45 |
| Example 6 | 2.0 | 12,000 | 345 | 63 |
| Example 7 | 1.9 | 10,500 | 330 | 73 |
| Example 8 | 3.4 | 7,400 | 290 | 49 |
| Example 9 | 2.2 | 9,500 | 295 | 55 |
| Example 10 | 2.0 | 13,400 | 350 | 64 |
| Example 11 | 1.8 | 11,500 | 310 | 63 |
| Example 12 | 3.7 | 6,400 | 260 | 43 |
| Example 13 | 2.2 | 11,400 | 290 | 62 |
| Example 14 | 1.9 | 10,700 | 300 | 59 |
| Example 15 | 2.0 | 9,300 | 290 | 51 |
| Example 16 | 2.4 | 12,000 | 310 | 55 |
| Example 17 | 2.3 | 9,800 | 280 | 64 |
| Example 18 | 2.5 | 10,500 | 300 | 58 |
| Example 19 | 2.4 | 8,800 | 290 | 46 |
| Comparative example 1 | 5.5 | 5,900 | 180 | 29 |
| Comparative example 2 | 6.1 | 4,200 | 140 | 21 |
| Comparative example 3 | 5.7 | 3,630 | 170 | 15 |
| Comparative example 4 | 4.5 | 4,000 | 150 | 19 |
| Comparative example 5 | 4.8 | 5,600 | 80 | 25 |
| Comparative example 6 | 2.3 | 10,020 | 310 | 39 |
| Comparative example 7 | 2.4 | 9,200 | 300 | 40 |
| Comparative example 8 | 2.8 | 7,700 | 290 | 25 |
| Comparative example 9 | 2.9 | 8,400 | 315 | 23 |
| Comparative example 10 | 2.8 | 4,700 | 300 | 38 |
| Comparative example 11 | 2.9 | 4,400 | 255 | 25 |
| Comparative example 12 | 2.5 | 6,000 | 300 | 20 |
| Comparative example 13 | 2.9 | 5,400 | 270 | 24 |

As is clearly understood from Table 3, the organic EL devices shown in Examples 1 to 19, which are made of materials of which the charge injection material has a substituted hydrolytic group-containing silicon group, give, after hardening, a buffer layer resistant to bleeding to the neighboring layers, superior in adhesiveness to the anode (ITO electrode), and improved in charge-injecting efficiency and charge balance, which is also superior in charge injecting efficiency, and thus, are more reliable, higher in brightness and performance than the organic EL devices of Comparative Examples 1 to 5 having no buffer layer.

As is clearly understood from comparison between the organic EL devices of Examples 3 and 11 with those of Comparative Examples 6 and 7, even when a buffer layer possibly containing a low-molecular weight component causing bleeding is used, the organic EL devices of Examples 3 and 11 containing the charge injection material in the exemplary embodiment in the buffer layer are superior in device lifetime.

In addition, as is clearly understood from comparison of the organic EL devices of Example 3 and 11 with those of Comparative Examples 9 to 11, the organic EL devices of Examples 3 and 11 using the charge-transporting polyether in the exemplary embodiment are more superior in device lifetime and luminescence brightness. Apparently, it is because the adhesiveness to the buffer layer and the charge-transporting efficiency are improved by using the charge-transporting polyether of the exemplary embodiment.

In addition, there is no pinhole or separation defect during film formation in any Example. Because it is possible to form a favorable thin film for example by spin coating or dip coating, it is possible to increase the device area easily without defects such as pinhole and to give an organic EL device superior in durability and light-emitting characteristics.

The foregoing description of the embodiments of the present invention has been provided for the purposes of illustration and description. It is not intended to be exhaustive or to limit the invention to the precise forms disclosed. Obviously, many modifications and variations will be apparent to practitioners skilled in the art. The embodiments were chosen and described in order to best explain the principles of the invention and its practical applications, thereby enabling others skilled in the art to understand the invention for various embodiments and with the various modifications as are suited to the particular use contemplated. It is intended that the scope of the invention be defined by the following claims and their equivalents.
All publications, patent applications, and technical standards mentioned in this specification are herein incorporated by reference to the same extent as if each individual publication, patent application, or technical standard was specifically and individually indicated to be incorporated by reference.

## Claims

1. An organic electroluminescent device comprising an electrode pair of an anode and a cathode, at least one of which is transparent or translucent, and an organic compound layer disposed between the anode and the cathode,
the organic compound layer comprising two or more layers including at least a buffer layer and a light-emitting layer;
at least one of the layers of the organic compound layer comprising at least one charge-transporting polyether represented by the following Formula (I); and
the buffer layer being provided in contact with the anode and comprising a crosslinked compound formed by using at least one charge injection material having a substituted silicon group represented by the following Formula (III): 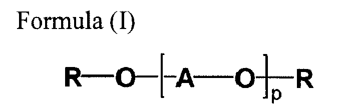 in Formula (I), A represents at least one structure represented by the following Formula (II-1) or (II-2); R represents a hydrogen atom, an alkyl group, a substituted or unsubstituted aryl group, a substituted or unsubstituted aralkyl group, an acyl group, or a group represented by -CONH-R', in which R' represents a hydrogen atom, an alkyl group, a substituted or unsubstituted aryl group, or a substituted or unsubstituted aralkyl group; and p is an integer of 5 to 5,000, 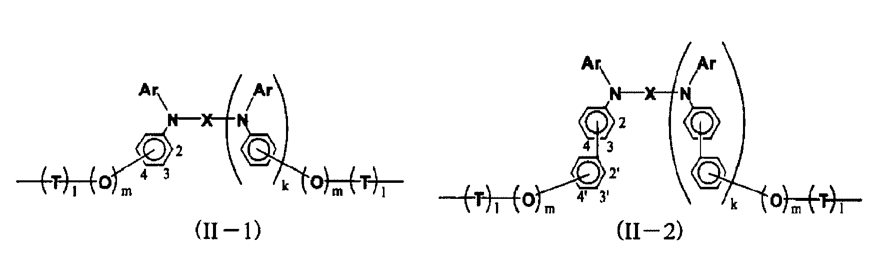 in Formulae (II-1) and (I-2), Ar represents a substituted or unsubstituted monovalent aromatic group; X represents a substituted or unsubstituted divalent aromatic group; k, m, and 1 each is 0 or 1; T represents a divalent straight-chain hydrocarbon having 1 to 6 carbon atoms or a branched hydrocarbon having 2 to 10 carbon atoms, and 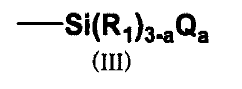 in Formula (III), R₁ represents a hydrogen atom, an alkyl group, or a substituted or unsubstituted aryl group; Q represents a hydrolyzable group; and a is an integer of 1 to 3.

2. The organic electroluminescent device of claim 1, wherein the charge injection material comprises at least one aromatic amine compound represented by any one of the following Formulae (IV-1) to (IV-4): 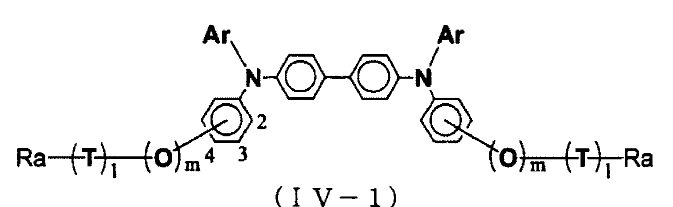 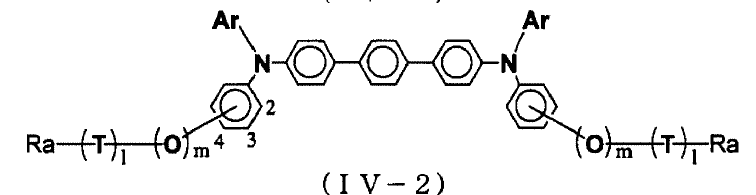 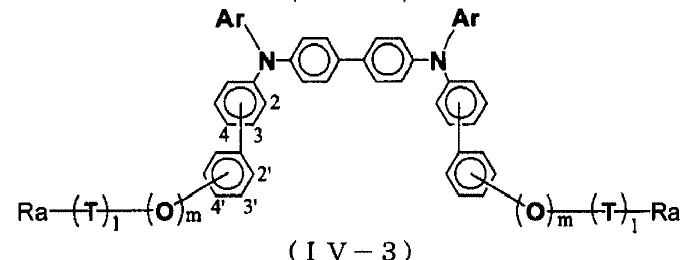 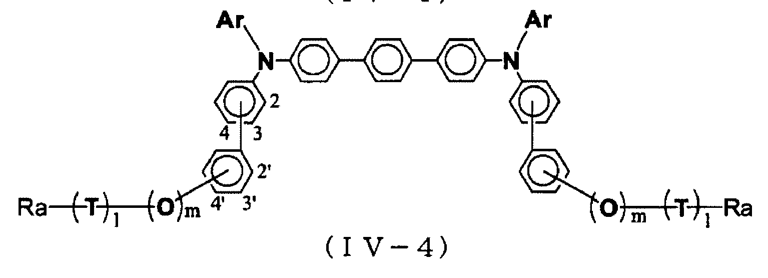 wherein in Formulae (IV-1) to (IV-4), Ar represents a substituted or unsubstituted monovalent aromatic group; Ra represents at least one substituted silicon group represented by the Formula (III); each of m and 1 is respectively 0 or 1; and T represents a divalent straight-chain hydrocarbon having 1 to 6 carbon atoms or a branched hydrocarbon having 2 to 10 carbon atoms.

3. The organic electroluminescent device of claim 1, wherein the organic compound layer comprises the buffer layer, the light-emitting layer, and an electron-transporting layer disposed in this order from the anode side, and at least one of the light-emitting layer and the electron-transporting layer comprises at least one charge-transporting polyether represented by the Formula (I).

4. The organic electroluminescent device of claim 3, wherein the light-emitting layer further comprises a charge-transporting material other than the charge-transporting polyether.

5. The organic electroluminescent device of claim 1, wherein the organic compound layer comprises the buffer layer, a hole-transporting layer, the light-emitting layer, and an electron-transporting layer disposed in this order from the anode side, and at least one of the hole-transporting layer, the light-emitting layer and the electron-transporting layer comprises at least one charge-transporting polyether represented by the Formula (I).

6. The organic electroluminescent device of claim 5, wherein the light-emitting layer further comprises a charge-transporting material other than the charge-transporting polyether.

7. The organic electroluminescent device of claim 1, wherein the organic compound layer comprises the buffer layer, a hole-transporting layer, and the light-emitting layer disposed in this order from the anode side, and
at least one of the hole-transporting layer and the light-emitting layer comprises at least one charge-transporting polyether represented by the Formula (I).

8. The organic electroluminescent device of claim 7, wherein the light-emitting layer further comprises a charge-transporting material other than the charge-transporting polyether.

9. The organic electroluminescent device of claim 1, wherein the organic compound layer comprises the buffer layer and the light-emitting layer disposed in this order from the anode side, the light-emitting layer having a charge-transporting property, and
the light-emitting layer having a charge-transporting property comprises at least one charge-transporting polyether represented by the Formula (I).

10. The organic electroluminescent device of claim 9, wherein the light-emitting layer further comprises a charge-transporting material other than the charge-transporting polyether.

11. A display device comprising:
a substrate;
a plurality of organic electroluminescent devices disposed on the substrate and arranged in a matrix form; and
a driving unit to drive the organic electroluminescent devices, each of the organic electroluminescent devices being the organic electroluminescent device of any one of claims 1 to 10.
